(19) Europäisches Patentamt

**European Patent Office**

**Office européen des brevets**

(11) Veröffentlichungsnummer: **0 338 122 B1**

(12) **EUROPÄISCHE PATENTSCHRIFT**

(45) Veröffentlichungstag der Patentschrift: **10.03.93**

(21) Anmeldenummer: **88119272.8**

(22) Anmeldetag: **19.11.88**

(51) Int. Cl.⁵: **H01L 27/22**, G01R 33/06

(54) **Integrierte Halbleiterschaltung mit einem Magnetfeldsensor aus Halbleitermaterial.**

(30) Priorität: **21.04.88 CH 1504/88**

(43) Veröffentlichungstag der Anmeldung:
**25.10.89 Patentblatt 89/43**

(45) Bekanntmachung des Hinweises auf die
Patenterteilung:
**10.03.93 Patentblatt 93/10**

(84) Benannte Vertragsstaaten:
**AT CH DE ES FR GB GR IT LI SE**

(56) Entgegenhaltungen:
**EP-A- 0 010 125**
**US-A- 3 816 766**

**S.M. Sze: "Physics of Semiconductor Devices", 2. Auflage, John Wiley & Sons, New York 1981, Seiten 30-35**

(73) Patentinhaber: **Landis & Gyr Betriebs AG**

**CH-6301 Zug(CH)**

(72) Erfinder: **Hälg, Beat**
**Loretohöhe 5**
**CH-6300 Zug(CH)**
Erfinder: **De Vries, Jacob**
**Feldbergstrasse 2**
**CH-6311 Allenwinden(CH)**
Erfinder: **Furrer, Beat**
**Leigrüppenstrasse 6**
**CH-8932 Mettmenstetten(CH)**

**Beschreibung**

Die Erfindung bezieht sich auf eine integrierte Halbleiterschaltung mit einem Magnetfeldsensor aus Halbleitermaterial, insbesondere einem Hallelement, gemäss dem Oberbegriff eines der Ansprüche 1 bis 8.

Derartige Anordnungen werden z. B. in Leistungsmessern oder Elektrizitätszählern verwendet zur Bildung eines Spannungs/Strom-Produktes $u_N.i_N$ oder, unter Konstanthaltung der Spannung $u_N$, zum Messen eines elektrischen Stromes $i_N$. Dabei bezeichnet $u_N$ vorzugsweise die Netzspannung eines elektrischen Versorgungsnetzes und $i_N$ den von einem Benützer elektrischer Energie verbrauchten oder gelieferten elektischen Strom. Da der Strom $i_N$ proportional einer von ihm erzeugten Magnetfeldinduktion $B_N$ ist, misst der Magnetfeldsensor indirekt den Strom $i_N$, wenn er die Magnetfeldinduktion $B_N$ ermittelt. Da die Ausgangsspannung $u_H$ eines als Magnetfeldsensor verwendeten Hallelementes proportional dem Produkt $i.B_N$ ist, wobei i den Speisestrom des Hallelementes darstellt, bildet das Hallelement auch das Spannungs/Strom-Produkt $u_N.i_N$, wenn der Speisestrom i des Hallelementes mit Hilfe eines Spannungsstrom-Wandlers proportional der Netzspannung $u_N$ erzeugt wird.

Bei Verwendung von Magnetfeldsensoren in Präzisionsinstrumenten ergeben sich entsprechend hohe Anforderungen an deren Langzeitstabilität, die beim Einbau in integrierten Schaltungen nicht ohne weiteres gewährleistet sind. Unter anderem wird die Langzeitstabilität eines aus Halbleitermaterial hergestellten Magnetfeldsensors durch kleine Änderungen in der Ladungsträgerkonzentration des Halbleitermaterials beeinträchtigt.

Die Änderungen in der Ladungsträgerkonzentration des Halbleitermaterials eines Magnetfeldsensors, z. B. durch "traps" in der Bandlücke, beeinflussen direkt die Ausgangsspannung des Magnetfeldsensors und damit deren Langzeitstabilität. Jede Verunreinigung in einem der Herstellungsprozesse kann, durch ein späteres Eindiffundieren von Ionen in das empfindliche Gebiet des Magnetfeldsensors, dort Ladungsträger erzeugen und zu einer Änderung der Empfindlichkeit des Magnetfeldsensors führen.

Aus der EP-A-0 010 125 ist eine integrierte Halbleiterschaltung bekannt zur Kompensation von Schwankungen des Herstellungsverfahrens eines Hallelementes. Letzteres wird dabei von einer Stromquelle mit einem vom Eingangswiderstand des Hallelementes unabhängigen Strom gespeist. Die Stromquelle ist gleichzeitig ein Impedanzwandler und enthält einen strombestimmenden Widerstand, welcher im gleichen Halbleitermaterial eindiffundiert ist wie das Hallelement. Der Ausgangsstrom der Stromquelle ist umgekehrt proportional zum strombestimmenden Widerstand, der seinerseits sowohl umgekehrt proportional zur Ladungsträgerkonzentration des Widerstandes als auch umgekehrt proportional zur innerhalb des Widerstandes vorhandenen Elektronenbeweglichkeit ist. Die Hallspannung eines Hallelementes ist bekanntlich proportional zum Speisestrom und umgekehrt proportional zur Ladungsträgerkonzentration des Hallelementes, jedoch unabhängig von der Elektronenbeweglichkeit innerhalb des letzteren. Falls die Ladungsträgerkonzentrationen des Hallelementes und des strombestimmenden Widerstandes gleich gross gewählt werden, eliminiert sich zwar deren Einfluss, jedoch nicht der Einfluss der Elektronenbeweglichkeit auf das Ausgangssignal der Halbleiterschaltung. Letzteres ist daher zwar langzeitstabil, jedoch auch sehr temperaturabhängig, da die Elektronenbeweglichkeit extrem temperaturabhängig ist.

Aus der US-A-3 816 766 ist eine integrierte Halbleiterschaltung bekannt, die aus der Kaskadenschaltung eines Hallelementes und eines nachgeschalteten Verstärkers besteht, der im gleichen Halbleitermaterial eindiffundiert ist wie das Hallelement. Die Temperaturabhängigkeit von Emitterwiderständen, Kollektorwiderständen, Transistorparametern und/oder Stromquellenwiderständen des Verstärkers wird dazu ausgenutzt, um mittels des daraus resultierenden temperaturabhängigen Verstärkungsfaktors des Verstärkers die Temperaturunabhängigkeit der Halbleiterschaltung zu verbessern. Eine langzeitstabilisierende Wirkung auf das Ausgangssignal der Halbleiterschaltung ist dabei nicht ersichtlich.

Der Erfindung liegt die Aufgabe zugrunde, eine Anordnung zu finden, die die negativen Einflüsse kleiner Instabilitäten in der Ladungsträgerkonzentration des Halbleitermaterials auf die Langzeitstabilität eines Magnetfeldsensors annulliert oder mindestens stark reduziert.

Die genannte Aufgabe wird gemäß den unterschiedlichen Varianten der Erfindung durch die im Kennzeichen der unabhängigen Ansprüche 1-8 angegebenen Merkmale gelöst.

Ausführungsbeispiele der Erfindung sind in der Zeichnung dargestellt und werden im folgenden näher beschrieben. Gleiche Bezugszeichen bezeichnen in allen Figuren der Zeichnung gleiche Teile.

Es zeigen:

Fig. 1    ein Blockschaltbild einer ersten Variante der erfindungsgemässen Anordnung,

Fig. 2    ein Blockschaltbild einer zweiten Variante der erfindungsgemässen Anordnung,

Fig. 3    ein Blockschaltbild einer dritten und vierten Variante der erfindungsgemässen Anordnung,

Fig. 4    ein Anschluss-Schaltbild eines vertikalen Hallelementes,

Fig. 5    ein Schaltbild eines Spannungs/Strom-Wandlers,

EP 0 338 122 B1

Fig. 6      ein Schaltbild einer ersten Variante eines Verstärkers,

Fig. 7      ein Schaltbild einer zweiten Variante des Verstärkers,

Fig. 8      eine schematische Darstellung des räumlichen, integrierten Aufbaus eines vertikalen Hallelementes und zweier dazugehöriger Widerstände des Verstärkers,

Fig. 9      ein Blockschaltbild einer dritten Variante des Verstärkers,

Fig. 10     ein Schaltbild eines mit geschalteten Kapazitäten aufgebauten Verstärkers,

Fig. 11     einen Querschnitt durch einen Aufbau eines vertikalen Hallelementes und eines Sperrschicht-Kondensators,

Fig. 12     ein Blockschaltbild einer weiteren Magnetfeldsensor-Schaltung,

Fig. 13     ein Blockschaltbild einer fünften Variante der erfindungsgemässen Anordnung und

Fig. 14     ein Schaltbild eines Impedanzwandlers.

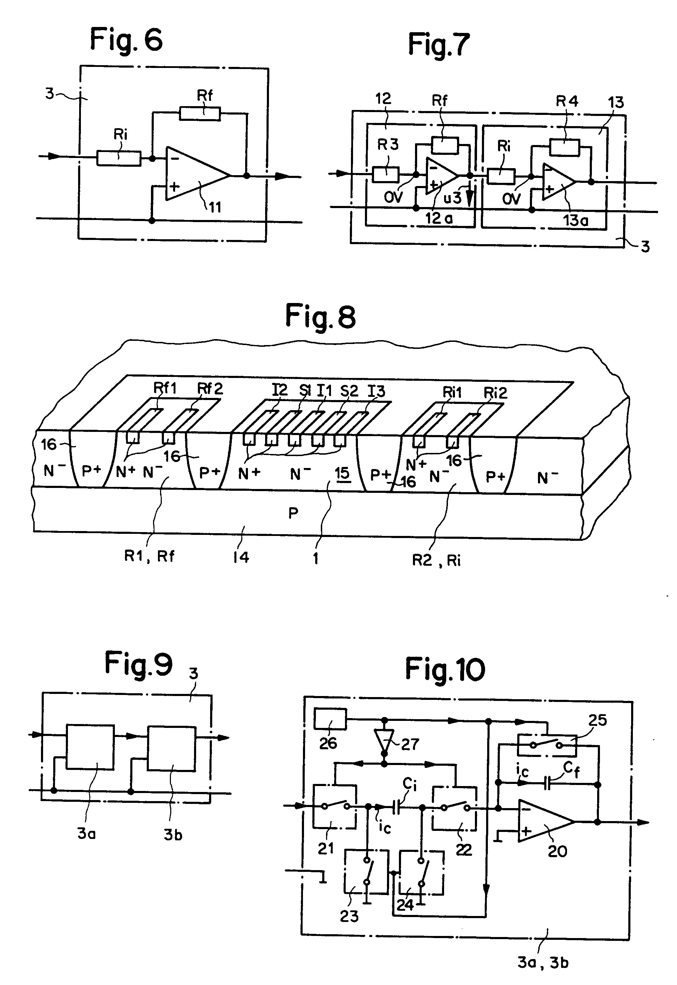

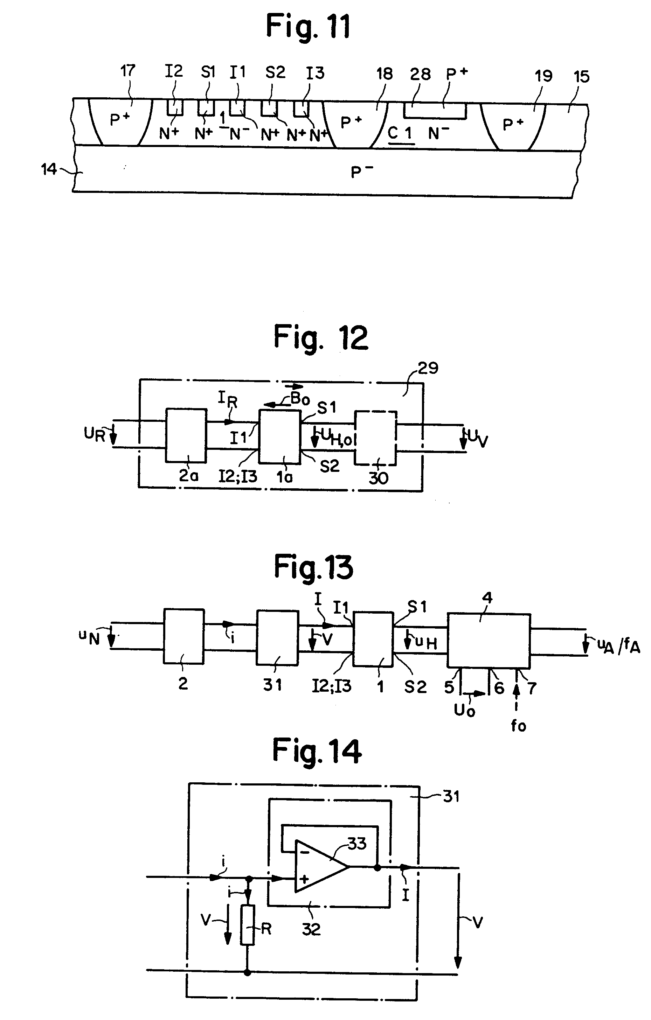

Die in den Figuren 8 und 11 wiedergegebenen schematischen Darstellungen sollen nur die relative räumliche Lage der Bauelemente verdeutlichen und erheben keinen Anspruch auf Vollständigkeit. Insbesondere sind keine Anschlüsse, Kontaktierungen, Verdrahtungen und Abdeckschichten dargestellt.

In der Zeichnung wurde immer angenommen, dass der Magnetfeldsensor ein Hallelement ist.

Der Magnetfeldsensor ist in allen Varianten jeweils einer zu messenden Magnetfeldinduktion $B_N$ ausgesetzt, die proportional dem Strom $i_N$ ist, und besteht vorzugsweise aus N-dotiertem Material. Unter der Annahme, dass der Magnetfeldsensor ein Hallelement ist, ist seine Ausgangsspannung gleich der bekannten Hallspannung:

$$u_H(n) = (k/n).i.B_N,$$

wobei $k = (g.s)/(e.d)$ ist, mit

$(k/n)$ :      Hallkonstante,

$n$ :      Ladungsträgerkonzentration des Halbleitermaterials aus dem der Magnetfeldsensor hergestellt ist (Dotierung), d. h. Elektronenkonzentration des aus N-dotiertem Halbleitermaterial hergestellten Hallelementes,

$g$ :      Geometriefaktor des Hallelementes,

$s$ :      Hall-Streufaktor (annähernd gleich 1),

$e$ :      Ladung eines Elektrons,

$d$ :      Dicke des Hallelementes in Richtung der Magnetfeldinduktion $B_N$.

Wenn sich im Laufe der Zeit die Ladungsträgerkonzentration eines Magnetfeldsensors, dessen Ausgangsspannung $u_H$ umgekehrt proportional dieser Ladungsträgerkonzentration ist, von $n$ auf $n + \delta n$ ändert, wobei $\delta n$ die zeitliche Änderung der Ladungsträgerkonzentration $n$ bezeichnet, dann nimmt die Hallspannung einen neuen Wert

$$u_H(n+\delta n) = [k/(n+\delta n)].i.B_N = [n/(n+\delta n)].(k/n).i.B_N$$
$$= [1/(1+\delta n/n)].u_H(n) \tag{I}$$

an.

Da das Ausgangsnutzsignal der erfindungsgemässen Anordnung proportional der Ausgangsspannung des Magnetfeldsensors und damit proportional der abgewanderten Hallspannung $u_H(n + \delta n)$ ist, muss somit in allen Varianten, um die Langzeitabweichung der Hallspannung zu kompensieren, ein das Ausgangsnutzsignal der Anordnung proportional miterzeugendes Signal mit einem Korrekturfaktor multipliziert werden, der proportional $(1 + \delta n/n)$ ist. In diesem Fall ist dann das Ausgangsnutzsignal der Anordnung unabhängig von $\delta n/n$. Ein das Ausgangsnutzsignal der Anordnung miterzeugendes Signal wird zu diesem Zweck in der Anordnung über ein Korrekturglied dem Ausgang der Anordnung zugeführt. In den beiden ersten Varianten und in der fünften Variante besitzt das Korrekturglied ein Übertragungsverhältnis, das proportional dem Faktor $(1 + \delta n/n)$ ist, und in der dritten und vierten Variante ein Übertragungsverhältnis, das proportional dem Faktor $(1-\delta n/n)$ ist.

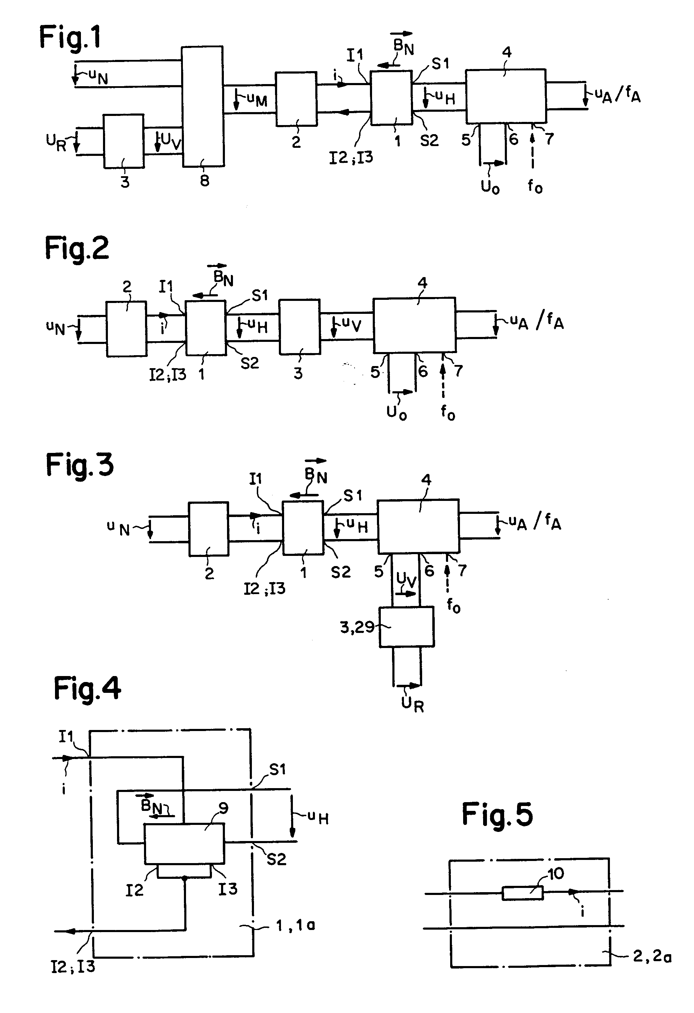

In den drei ersten Varianten (siehe Figuren 1 bis 3) besteht die erfindungsgemässe Anordnung jeweils aus mindestens einem Magnetfeldsensor 1, einem Spannungs/Strom-Wandler 2, einem Verstärker 3 und einem dem Magnetfeldsensor 1 nachgeschalteten Wandler 4. Das Korrekturglied der drei ersten Varianten ist der Verstärker 3, dessen Verstärkungsfaktor in den beiden ersten Varianten proportional dem Faktor $(1 + \delta n/n)$ und in der dritten Variante proportional dem Faktor $(1-\delta n/n)$ ist.

3

Der nachfolgend in allen Varianten der erfindungsgemässen Anordnung verwendete Wandler 4 ist jeweils entweder ein Analog/Digital-Wandler oder ein Spannungs/Frequenz-Wandler. Die Ausgangsspannung $u_A$ des Wandlers 4 ist immer auch die Ausgangsspannung der erfindungsgemässen Anordnung. Das Ausgangsnutzsignal der Anordnung, welches proportional der Ausgangsspannung $u_H$ des Magnetfeldsensors 1 ist, ist also demnach entweder ein digitaler Ausgangswert der Ausgangsspannung $u_A$ des Wandlers 4, wenn dieser ein Analog/Digital-Wandler ist, oder eine Ausgangsfrequenz $f_A$ des Wandlers 4, wenn dieser ein Spannungs/Frequenz-Wandler ist. Der Wandler 4 besitzt einen zweipoligen Referenzspannungseingang 5; 6 und, wenn er ein Spannungs/Frequenz-Wandler ist, noch zusätzlich einen Referenzfrequenzeingang 7. Falls der Wandler 4 ein Spannungs/Frequenz-Wandler ist, gilt vorläufig die Annahme, dass sein Referenzfrequenzeingang 7 mit einer konstanten Referenzfrequenz $f_o$ gespeist ist. Der innere Aufbau des Wandlers 4 wird nachfolgend nicht näher beschrieben, da Analog/Digital-Wandler und Spannungs/Frequenz-Wandler bekannte und gebräuchliche Bauelemente der Elektronik sind, die jedem Fachmann bekannt und im Handel erhältlich sind.

In den drei ersten Varianten ist eine Spannung $u_M$ (siehe Fig. 1) bzw. eine Netzspannung $u_N$ (siehe Fig. 2 und Fig. 3) jeweils zweipolig auf einen Spannungseingang des Spannungs/Strom-Wandlers 2 geführt. Der Stromausgang des Spannungs/Strom-Wandlers 2 ist seinerseits jeweils zweipolig mit einem Speisestromeingang I1; I2; I3 des Magnetfeldsensors 1 verbunden. Die Spannung $u_M$ bzw. die Netzspannung $u_N$ wird im Spannungs/Strom-Wandler 2 in einen proportionalen Strom i umgewandelt, der den Magnetfeldsensor 1 speist.

In der in der Fig. 1 dargestellten ersten Variante ist der Ausgang S1; S2 des Magnetfeldsensors 1 zweipolig direkt mit einem Signaleingang des Wandlers 4 verbunden, dessen Referenzspannungseingang 5; 6 mit einer konstanten Referenzspannung $U_O$ gespeist ist. Am Eingang des Verstärkers 3 steht eine konstante Referenzspannung $U_R$ an, während sein Ausgang zweipolig mit einem ersten Eingang eines Multiplizierers 8 verbunden ist, dessen zweiter Eingang von der Netzspannung $u_N$ gespeist ist. Die Ausgangsspannung des Verstärkers 3 ist mit $U_V$ bezeichnet. Die bereits erwähnte Spannung $u_M$ ist die Ausgangsspannung des Multiplizierers 8 und demnach gleich dem Produkt $u_N.U_V$ von dessen beiden Eingangsspannungen. Der Ausgang des Multiplizierers 8 ist somit über den Spannungs/Strom-Wandler 2 mit dem Speisestromeingang I1; I2; I3 des Magnetfeldsensors 1 verbunden. Der Multiplizierer 8 ist ein an sich bekanntes und im Handel erhältliches Bauelement.

In der in der Fig. 2 dargestellten zweiten Variante ist der Ausgang S1; S2 des Magnetfeldsensors 1 zweipolig mit dem Eingang des Verstärkers 3 verbunden, dessen Ausgang seinerseits zweipolig auf den Signaleingang des Wandlers 4 geführt ist. Der Verstärker 3 ist somit dem Magnetfeldsensor 1 in Kaskade nachgeschaltet. Der Referenzspannungseingang 5; 6 des Wandlers 4 liegt wieder an der konstanten Referenzspannung $U_O$.

In der in der Fig. 3 dargestellten dritten Variante ist der Ausgang S1; S2 des Magnetfeldsensors 1 direkt zweipolig auf den Signaleingang des Wandlers 4 geführt, dessen Referenzspannungseingang 5; 6 diesmal mit dem Ausgang des Verstärkers 3 verbunden ist, an dessen Eingang die konstante Referenzspannung $U_R$ ansteht.

In der ersten Variante ist der Verstärker 3 als Korrekturglied in einem Speisestrom-Eingangskreis 2; 3; 8 des Magnetfeldsensors 1 derartig angeordnet, dass der Speisestrom i des Magnetfeldsensors 1 mit einem Faktor multipliziert wird, der proportional dem Faktor $(1+\delta n/n)$ ist. In diesem Fall ist nämlich die Ausgangsspannung $U_V$ des Verstärkers 3 proportional $(1+\delta n/n).U_R$ und der Speisestrom i somit proportional dem Produkt $u_N.(1+\delta n/n)$.

In der zweiten Variante erfolgt die Multiplikation am Ausgang des Magnetfeldsensors 1, indem dessen Ausgangsspannung $u_H$ durch den in Kaskade nachgeschalteten Verstärker 3 direkt mit dessen Verstärkungsfaktor $(1+\delta n/n)$ multipliziert wird.

In den beiden ersten Varianten ist somit, unter Berücksichtigung der Gleichung I, die Eingangsspannung des Wandlers 4 proportional dem Wert:

$$u_H(n+\delta n).(1+\delta n/n)=[1/(1+\delta n/n)].u_H(n).(1+\delta n/n)$$
$$=u_H(n),$$

der, wie angestrebt, unabhängig von der Änderung $\delta n$ der Ladungsträgerkonzentration n im Magnetfeldsensor 1 ist.

EP 0 338 122 B1

Wenn der Wandler 4 ein Analog/Digital-Wandler ist, ist der dann dimensionslose digitale Ausgangswert der Ausgangsspannung $u_A$ des Wandlers 4 proportional der in Volt ausgedrückten Eingangsspannung des Wandlers 4, wobei der Proportionalitätsfaktor die Dimension 1/Volt besitzt und selber umgekehrt proportional der am Referenzspannungseingang 5; 6 des Wandlers 4 anstehenden Referenzspannung $U_O$ (siehe Fig. 1 und Fig. 2) bzw. $U_V$ (siehe Fig. 3) ist. Anders ausgedrückt: Der Proportionalitätsfaktor ist in den beiden ersten Varianten proportional $1/U_O$ und in der dritten Variante proportional $1/U_V$.

Wenn der Wandler 4 dagegen ein Spannungs/Frequenz-Wandler ist, ist dessen Ausgangsfrequenz $f_A$, die eine Dimension 1/Sekunden besitzt, proportional der in Volt ausgedrückten Eingangsspannung des Wandlers 4, wobei der Proportionalitätsfaktor diesmal eine Dimension 1/(Sekunden.Volt) besitzt und selber einerseits proportional der am Referenzfrequenzeingang 7 des Wandlers 4 anstehenden Referenzfrequenz $f_O$ und anderseits umgekehrt proportional der am Referenzspannungseingang 5; 6 des Wandlers 4 anstehenden Referenzspannung $U_O$ (siehe Fig. 1 und Fig. 2) bzw. $U_V$ (siehe Fig. 3) ist. Anders ausgedrückt: Auch hier ist der Proportionalitätsfaktor in den beiden ersten Varianten proportional $1/U_O$ und in der dritten Variante proportional $1/U_V$. Dieser Proportionalitätsfaktor ist ausserdem in allen Varianten noch proportional dem Faktor $f_O$. Somit wird, unabhängig davon, ob der Wandler 4 ein Analog/Digital-Wandler oder ein Spannungs/Frequenz-Wandler ist, im Wandler 4 dessen Eingangsspannung in den beiden ersten Varianten durch die konstante Referenzspannung $U_O$ und in der dritten Variante durch die Ausgangsspannung $U_V$ des Verstärkers 3 geteilt.

Da in den beiden ersten Varianten $\delta n$ bereits, wie schon ausführlich erläutert, sei es am Eingang, sei es am Ausgang des Magnetfeldsensors 1 eliminiert wurde und somit nicht mehr im Wert der Eingangsspannung des Wandlers 4 enthalten ist, und da die Referenzspannung $U_O$ konstant ist, ist das Nutzausgangssignal der Anordnung, nämlich der digitale Ausgangswert, wenn der Wandler 4 ein Analog/Digital-Wandler ist, oder die Ausgangsfrequenz $f_A$, wenn der Wandler 4 ein Spannungs/Frequenz-Wandler ist, wie angestrebt unabhängig von der Änderung $\delta n$ der Ladungsträgerkonzentration n im Magnetfeldsensor 1.

In der dritten Variante dagegen ist die Eingangsspannung des Wandlers 4 die noch nicht korrigierte Ausgangsspannung

$$u_H(n + \delta n) = [1/(1 + \delta n/n)].u_H(n)$$

des Magnetfeldsensors 1.

Die Korrektur, d. h. die Multiplikation mit dem Faktor $(1 + \delta n/n)$, erfolgt in der dritten Variante innerhalb des Wandlers 4, indem dort die Eingangsspannung $u_H$ des Wandlers 4 durch die am Referenzspannungseingang 5; 6 anstehende Ausgangsspannung $U_V$ des Verstärkers 3 geteilt wird. Der Verstärker 3 hat hier, wie bereits erwähnt, nicht einen Verstärkungsfaktor $(1 + \delta n/n)$, sondern einen Verstärkungsfaktor $(1-\delta n/n)$, so dass die Ausgangsspannung des Verstärkers 3 diesmal einem Wert

$$U_V = U_R.(1-\delta n/n)$$

entspricht.

Die Eingangsspannung $u_H$ des Wandlers 4 wird somit im Wandler 4 durch $(1-\delta n/n)$ geteilt, was bei einem sehr kleinen Wert von $(\delta n/n)$ einer Multiplikation mit dem Faktor $(1 + \delta n/n)$ gleich kommt, da dann bekanntlich $[1/(1-\delta n/n)] = (1 + \delta n/n)$, wie die Zerlegung in einer Reihe zeigt, in der die Terme zweiter und höherer Ordnung als vernachlässigbar klein gleich Null gesetzt werden. Durch diese Multiplikation mit dem Faktor $(1 + \delta n/n)$ wird der im Wert der Eingangsspannung des Wandlers 4 (siehe Gleichung I) enthaltene Faktor $[1/(1 + \delta n/n)]$ eliminiert, so dass das Ausgangsnutzsignal des Wandlers 4 wieder, wie bei den beiden ersten Varianten, unabhängig von der Änderung $\delta n$ der Ladungsträgerkonzentration n im Magnetfeldsensor 1 ist.

Sämtliche hier verwendete Hallelemente können entweder vertikale oder horizontale Hallelemente sein. Ein vertikales Hallelement ist z. B. in der Druckschrift IEEE Electron Device Letters, Vol. EDL-5, No. 9, Sept. 84, Seiten 357 und 358, "The vertical hall-effect device", R. S. Popovic, beschrieben, während ein horizontales Hallelement z. B. aus der US-PS 4 253 107 bekannt ist. Vertikale Hallelemente sind Hallelemente, die Magnetfelder messen, die parallel zur Oberfläche des Hallelementes wirksam sind, während horizontale Hallelemente dagegen Magnetfelder messen, die senkrecht zur Oberfläche des Hallelementes gerichtet sind. Nachfolgend wird angenommen, dass alle in den beschriebenen Anordnungen verwendeten Hallelemente vertikale Hallelemente sind. In diesem Fall besitzt jedes dieser Hallelemente drei Stromanschlüsse I1, I2 und I3, die zusammen seinen Speisestromeingang I1; I2; I3 bilden, sowie zwei Sensoranschlüsse S1 und S2, die in der Reihenfolge I2, S1, I1, S2 und I3, z. B. von links nach rechts, in der Darstellung der Zeichnung parallel nebeneinander angeordnet sind (siehe Fig. 8 und Fig. 11). Die beiden

5

räumlich aussen gelegenen Stromanschlüsse I2 und I3 des vertikalen Hallelementes sind entweder über je einen Widerstand oder, wie in der Fig. 4 für ein vertikales Hallelement 9 dargestellt, direkt miteinander verbunden, wobei ein so entstandener gemeinsamer Verbindungspunkt I2; I3 einen der beiden Pole des Speisestromeingangs I1; I2; I3 bildet. Ein vom Spannungs/Strom-Wandler 2 gelieferter Speisestrom i des Hallelementes 1 fliesst somit z. B. beim Stromanschluss I1 in das Hallelement hinein, um sich innerhalb desselben zu teilen, wobei die Teilströme bei den Stromanschlüssen I2 und I3 das Hallelement verlassen, um sich anschliessend wieder zu addieren zwecks Bildung des Gesamtwertes des Speisestroms i. Die Sensoranschlüsse S1 und S2 bilden den zweipoligen Ausgang der Hallelemente, an dem die Hallspannung $u_H$ ansteht, wobei der Sensoranschluss S2 entweder virtuell oder direkt an Masse liegen kann. Ein Ausgangspol des Hallelementes kann virtuell an Masse gelegt werden, indem er als Istwertpol mit einem invertierenden Eingang eines nichtdargestellten Verstärkers verbunden wird, der als Regelverstärker arbeitet und an dessen nichtinvertierendem Eingang als Sollwert eine konstante Referenzspannung liegt, die im Idealfall gleich null Volt ist, während der Ausgang dieses Regelverstärkers mit einem Pol, z. B. I2; I3, des Speisestromeingangs des Magnetfeldsensors 1 verbunden ist.

Der Spannungs/Strom-Wandler 2 besteht vorzugsweise aus einem einzigen Widerstand 10 und hat dann den in der Fig. 5 dargestellten Aufbau. In diesem liegt der Widerstand 10 zwischen einem ersten Pol des Spannungseingangs und einem ersten Pol des Stromausgangs des Spannungs/Strom-Wandlers 2, während die zweite Pole dieses Spannungseingangs bzw. Stromausgangs jeweils direkt miteinander verbunden sind.

In den drei ersten Varianten besitzt der Verstärker 3 vorzugsweise den in einer der drei Figuren 6, 7 oder 9 dargestellten Aufbau.

In dem in der Figur 6 dargestellten Aufbau besitzt der Verstärker einen Verstärkungsfaktor, der proportional einem Verhältnis Rf/Ri der Widerstandswerte zweier eindiffundierter Widerstände Rf und Ri ist, die, wie in der Fig. 8 dargestellt, nahe beim Magnetfeldsensor 1 und symmetrisch zu diesem mit annähernd dessen Abmessungen in einem Halbleitermaterial eindiffundiert sind, welches vom gleichen Leitfähigkeitstyp N ist wie dasjenige, aus dem der Magnetfeldsensor 1 hergestellt ist.

Gemäss der Fig. 6 besteht der Verstärker 3 aus einem an sich bekannten, mittels eines Operationsverstärkers 11 aufgebauten invertierenden Verstärker, der einen Rückkopplungswiderstand Rf und einen Eingangswiderstand Ri aufweist. Der Eingangswiderstand Ri ist dabei innerhalb des Verstärkers 3 dem invertierenden Eingang des Operationsverstärkers 11 vorgeschaltet, indem er zwischen einem ersten Pol des Eingangs des Verstärkers 3 und dem invertierenden Eingang des Operationsverstärkers 11 eingebaut ist. Der Rückkopplungswiderstand Rf ist zwischen diesem invertierenden Eingang und dem Ausgang des Operationsverstärkers 11 angeordnet. Der nichtinvertierende Eingang des Operationsverstärkers 11 liegt entweder über einem Widerstand oder, wie dargestellt, direkt an einem zweiten Eingangspol des Verstärkers 3, der gleichzeitig ein erster Ausgangspol des Verstärkers 3 ist. Der Ausgang des Operationsverstärkers 11 ist gleichzeitig der zweite Pol des Ausgangs des Verstärkers 3. Der Verstärkungsfaktor eines derartig aufgebauten invertierenden Verstärkers 3 ist bekanntlich gleich -(Rf/Ri).

Während die meisten anderen Widerstände in herkömmlicher, in integrierten Schaltungen üblicher Technologie hergestellt werden können, müssen die beiden Widerstände Rf und Ri als diffundierte Widerstände aus dem gleichen "Bulk"-Material hergestellt werden, aus dem auch der Magnetfeldsensor 1 hergestellt ist. Jeder aus N-dotiertem Material hergestellte Widerstand besitzt bekanntlich einen Wert:

$$R(m) = A/m \qquad (II),$$

wobei $A = 1/(G.e.\mu)$, mit:

m : Ladungsträger- bzw. Elektronenkonzentration (Dotierung) des Widerstandes,
G : Geometriefaktor des Widerstandes, wobei $G = b.t/L$ ist,
$\mu$ : Elektronenbeweglichkeit,
e : Ladung eines Elektrons,
b : Breite des Widerstandes,
t : Tiefe des Widerstandes und
L : Länge des Widerstandes.

In den beiden ersten Varianten wird Rf = R1 sowie Ri = R2 und in der dritten Variante umgekehrt Rf = R2 sowie Ri = R1 gewählt.

Der erste Widerstand R1 besitzt eine Ladungsträgerkonzentration m1, einen Geometriefaktor G1 und eine Elektronenbeweglichkeit $\mu$1, so dass sein Faktor A gleich A1 = $1/(G1.e.\mu1)$ und sein Widerstandswert R1 gleich R1(m) = A1/m1 ist.

6

Der zweite Widerstand R2 besitzt eine Ladungsträgerkonzentration m2 = a.m1, einen Geometriefaktor G2 und eine Elektronenbeweglichkeit $\mu2$, so dass sein Faktor A gleich A2 = 1/(G2.e.$\mu2$) und sein Widerstandswert R2 gleich R2(m) = A2/m2 = A2/(a.m1) ist.

Vorzugsweise wird für den Widerstand R1 ein Wert m1 = n gewählt, d. h. die Ladungsträgerkonzentration m1 im ersten Widerstand R1 wird gleich gross gewählt wie die im Magnetfeldsensor 1 existierende Ladungsträgerkonzentration n, so dass der Widerstandswert R1 dann gleich R1(n) = A1/n ist. Da der Widerstand R2 die a-fache Ladungsträgerkonzentration des Widerstandes R1 besitzt, ist in diesem Fall der Widerstandswert des Widerstandes R2 gleich R2(n) = A2/(an). Die Ladungsträgerkonzentration m2 des Widerstandes R2 ist dabei ein Multipel a.n der im Magnetfeldsensor 1 existierenden Ladungsträgerkonzentration n.

Wie bereits erwähnt, existiert für alle drei Bauelemente 1, R1 und R2 eine gleichgrosse zeitliche Änderung $\delta n$ der Ladungsträgerkonzentration n, so dass $\delta n = \delta m1 = \delta m2$ gilt. Das Widerstandsverhältnis R2/R1 hat zu Beginn den Wert:

(R2/R1) = (A2/m2)/(A1/m1) = (A2/A1).(m1/m2).

Nimmt der Widerstand R1 nach einer gewissen Zeit die Ladungsträgerkonzentration $m1 + \delta m1 = m1 + \delta n$ und der Widerstand R2 die Ladungsträgerkonzentration $m2 + \delta m2 = m2 + \delta n$ an, dann gilt:

(R2/R1) = (1/D).[(m1 + $\delta$n)/(m2 + $\delta$n)]     (III),

mit

(1/D) = A2/A1 = (G1.e.$\mu$1)/(G2.e.$\mu$2) = (G1/G2).($\mu$1/$\mu$2).     (IV)

Die Gleichung (III) kann wie folgt umgeformt werden:

```
(R1/R2)=D.(m2+δn)/(m1+δn)
        =D.(m2/m1).[1+(δn/m2)]/[1+(δn/m1)]
        =D.(m2/m1).[1+(δn/m1)(m1/m2)][1-(δn/m1)+(δn/m1)²-...]
```

mit $1/[1 + (\delta n/m1)] = 1 - (\delta n/m1) + (\delta n/m1)^{2-}...$

Mit (m2/m1) = a, m1 = n und unter Vernachlässigung der Termen zweiter und höherer Ordnung ergibt sich folgender Wert für das Widerstandsverhältnis:

```
(R1/R2)=(D)(m2/m1).{1-(δn/m1).[1-(m1/m2)]}
        =(a.D).{1-[1-(1/a)].(δn/n)}                              (V).
```

Vorzugsweise wird a = 1/2 gewählt, d. h. die Ladungsträgerkonzentration im zweiten Widerstand R2 wird gleich der halben, im Magnetfeldsensor 1 existierenden Ladungsträgerkonzentration n gewählt, so dass die Gleichung (V) folgendes Resultat ergibt:

```
(R1/R2)=(D/2).[1-(1-2)δn/n]
        =(D/2).(1+δn/n) oder
```

(R2/R1) = (2/D).(1-$\delta$n/n),

da wieder $1/(1 + \delta n/n)$ gleich $(1-\delta n/n)$ ist, wenn $\delta n/n$ sehr klein ist.

Das Verhältnis zweier unterschiedlich dotierter Widerstände R1 und R2 liefert somit direkt den gewünschten Faktor [1 + ($\delta$n/n)]. In den beiden ersten Varianten ist der Verstärkungsfaktor des Verstärkers 3 gleich

$$-(Rf/Ri) = -(R1/R2) = -(D/2).(1 + \delta n/n)$$

und somit, wie angestrebt, proportional $(1 + \delta n/n)$.

In der dritten Variante ist der Verstärkungsfaktor dagegen gleich

$$-(Rf/Ri) = -(R2/R1) = -(2/D).(1-\delta n/n)$$

und somit, wie angestrebt, proportional $(1-\delta n/n)$.

Die Geometrien G1 und G2 der durch Raumladungszonen begrenzten Widerstände R1 und R2 dürfen sich in Funktion der angelegten Spannung nicht ändern. Dies gilt vor allem für die zweite Variante (siehe Fig. 2), bei der am Eingang des Verstärkers 3 die variierende Hallspannung $u_H$ ansteht. Es gibt unter anderem die beiden nachfolgenden Methoden, um diese Änderungen zu vermeiden:

- Entweder werden die Abmessungen der Widerstände R1 und R2 gross gewählt gegenüber der Änderungen der Raumladungszonen und/oder die Vorspannung der sie begrenzenden Wannen wird gross gewählt gegenüber dem Spannungsabfall über den Widerständen,
- oder für den Verstärker 3 wird ein Schaltbild gemäss der Fig. 7 verwendet, in dem die Spannungsabfälle u3 in den beiden Widerständen Ri und Rf gleich gross sind.

Der in der Fig. 7 dargestellte Verstärker 3 besteht aus einer Kaskadenschaltung von zwei mit Hilfe je eines Operationsverstärkers 12a bzw. 13a aufgebauten invertierenden Verstärkern 12 und 13, die beide annähernd gleich aufgebaut sind, wie der in der Fig. 6 dargestellte invertierende Verstärker, mit dem Unterschied, dass in dem vorderen Verstärker 12 der beiden Verstärker der Eingangswiderstand nicht gleich Ri, sondern gleich einem dritten Widerstand R3 ist, und dass in dem hinteren Verstärker 13 der beiden Verstärker der Rückkopplungswiderstand nicht gleich Rf, sondern gleich einem vierten Widerstand R4 ist, wobei der dritte Widerstand R3 und der vierte Widerstand R4 in herkömmlicher, in integrierten Schaltungen üblicher Technologie hergestellt werden. Die Verstärker 12 und 13 bestehen somit jeweils aus je einem Operationsverstärker 12a bzw. 13a, je einem Rückkopplungswiderstand Rf bzw. R4 und je einem Eingangswiderstand R3 bzw. Ri. Der Eingangswiderstand Ri des hinteren Verstärkers 13 und der Rückkopplungswiderstand Rf des vorderen Verstärkers 12 haben wieder die gleiche Bedeutung wie in der in der Fig. 6 dargestellten Verstärkeranordnung.

In den beiden ersten Varianten ist somit wider Rf = R1 und Ri = R2, so dass der erste widerstand R1 als Rückkopplungswiderstand Rf zwischen dem Ausgang des Operationsverstärkers 12a des vorderen Verstärkers 12 und dem invertierenden Eingang dieses Operationsverstärkers 12a angeordnet ist. Der dritte Widerstand R3 ist diesem invertierenden Eingang des Operationsverstärkers 12a als Eingangswiderstand vorgeschaltet, während der vierte Widerstand R4 als Rückkopplungswiderstand zwischen dem Ausgang des Operationsverstärkers 13a des hinteren Verstärkers 13 und dem invertierenden Eingang dieses Operationsverstärkers 13a eingebaut ist. Der zweite Widerstand R2 ist als Eingangswiderstand Ri diesem invertierenden Eingang des Operationsverstärkers 13a vorgeschaltet.

In der dritten Variante ist dagegen wieder Rf = R2 und Ri = R1, so dass diesmal der zweite Widerstand R2 als Rückkopplungswiderstand Rf zwischen dem Ausgang des Operationsverstärkers 12a, des vorderen Verstärkers 12 und dem invertierenden Eingang dieses Operationsverstärkers 12a angeordnet ist. Der erste Widerstand R1 ist dagegen als Eingangswiderstand Ri dem invertierenden Eingang des Operationsverstärkers 13a vorgeschaltet.

Da bei den in der Fig. 7 verwendeten invertierenden Verstärkern 12 und 13 der invertierende Eingang der Operationsverstärker 12a und 13a auf gleichem Potential liegt, liegt über den beiden Widerständen Ri und Rf jeweils eine gleich großes Spannung u3, wobei u3 die Ausgangsspannung des vordersten invertierenden Verstärkers 12 bezeichnet.

Der in der Fig. 7 dargestellte Verstärker 3 besitzt einen Verstärkungsfaktor

$$(-Rf/R3).(-R4/Ri) = (Rf/Ri).(R4/R3).$$

Durch eine geeignete Wahl der Werte der Widerstände R3 und R4 wird das Eingangssignal des Verstärkers 3 entsprechend verstärkt, so dass sich in der zweiten Variante möglicherweise eine Vorverstärkung der Hallspannung $u_H$ erübrigt.

Der in der Fig. 8 teilweise dargestellte Aufbau der erfindungsgemässen Variante enthält ein aus P-Material bestehendes Substrat 14, auf dem eine Epitaxie-Schicht 15 aus schwach dotiertem N-Material aufgetragen ist. Aus der Fig. 8 ist schematisch ersichtlich, dass die beiden Widerstände Rf und Ri beiderseits des Magnetfeldsensors 1 parallel und in der Draufsicht symmetrisch zu diesem angeordnet sind, wobei alle drei Bauelemente 1, Rf und Ri räumlich möglichst nahe beieinander im N-dotierten Material der Epitaxie-Schicht 15 liegen, damit sie eine gleiche Temperatur annehmen und im Laufe der Zeit einer gleichen Dotierungsänderung $\delta n$ unterliegen. Die Widerstände Rf und Ri sind ausserdem symmetrisch zum Magnetfeldsensor 1 angeordnet, damit sie annähernd gleichen Piezowiderstandseffekten ausgesetzt sind, welche sich dann durch die Verhältnisbildung der Widerstände weitgehend aufheben. Damit die Widerstände Rf und Ri einer gleichen Änderung $\delta n$ in der Ladungsträgerkonzentration unterliegen wie der Magnetfeldsensor 1, müssen sie noch zusätzlich mit möglichst gleichen geometrischen Grössen, speziell mit gleichen Tiefen, und in gleicher Technologie, d. h. mit gleichen Prozessschritten, im empfindlichen Volumen hergestellt werden wie der Magnetfeldsensor 1.

Die Widerstände Rf und Ri sind dabei in vorteilhafter Weise genau wie der Magnetfeldsensor 1 seitlich durch Wannen 16 aus stark dotiertem P-Material ("P-Wells") begrenzt und nach oben mittels einer nichtdargestellten Abdeckschicht aus P-Material vergraben.

Die Anschlusskontakte I1, I2, I3, S1 und S2 des Magnetfeldsensors 1 sowie Rf1 und Rf2 des Widerstandes Rf und Ri1 sowie Ri2 des Widerstandes Ri bestehen alle aus stark dotiertem N-Material.

Der Widerstand R2 hat vorzugsweise die ursprüngliche, homogene Dotierung des Ausgangsmaterials, während der Magnetfeldsensor 1 und der Widerstand R1 die (1/a)-fache, d. h. mit a = 1/2 vorzugsweise die doppelte Dotierung des Ausgangsmaterials erhalten. Alle drei Bauelemente 1, R1 und R2 sind dabei vom gleichen Dotierungstyp, z. B. vom Typ N.

Der Verstärker 3 kann auch den in der Fig. 9 dargestellten Aufbau besitzen. Dieser Verstärker 3 besteht aus zwei Verstärkern 3a und 3b, die in der angegebenen Reihenfolge in Kaskade geschaltet sind, wobei ein einpoliger Ausgang des vordersten Verstärkers 3a mit einem ersten Eingangspol des nachfolgenden Verstärkers 3b verbunden ist, dessen einpoliger Ausgang einen ersten Ausgangspol des Verstärkers 3 bildet. Ein erster Eingangspol des vordersten Verstärkers 3a bildet einen ersten Eingangspol des Verstärkers 3. Die zweiten Eingangspole der Verstärker 3a und 3b sind miteinander verbunden und bilden zusammen einen zweiten Eingangspol des Verstärkers 3, der gleichzeitig ein zweiter Ausgangspol dieses Verstärkers 3 ist. Die Verstärker 3a und 3b sind beide gleich aufgebaut und mittels geschalteter Kapazitäten Cf und Ci verwirklicht ("switched capacitor amplifier"). Sie besitzen vorzugsweise den in der Fig. 10 dargestellten Aufbau.

Der in der Fig. 10 dargestellte Verstärker 3a bzw. 3b besteht aus einem Operationsverstärker 20, einem Rückkopplungskondensator Cf, einem Eingangskondensator Ci, fünf Schaltern 21 bis 25, die alle vorzugsweise Halbleiter-Analogschalter sind, einem astabilen Multivibrator 26 und einem Inverter 27. Ein erster Pol des Signaleingangs des Verstärkers 3a bzw. 3b ist innerhalb desselben auf einen ersten Pol des Schalters 21 geführt, dessen zweiter Pol mit je einem ersten Pol des Schalters 23 und des Eingangskondensators Ci verbunden ist. Der zweite Pol des letzten ist seinerseits auf je einen ersten Pol des Schalters 22 und 24 geführt, wobei der zweite Pol des Schalters 22 mit dem invertierenden Eingang des Operationsverstärkers 20 sowie mit je einem ersten Pol des Schalters 25 und des Rückkopplungskondensators Cf verbunden ist. Der zweite Pol des Schalters 25 und des Rückkopplungskondensators Cf sind auf den Ausgang des Operationsverstärkers 20 geführt, der gleichzeitig der Ausgang des Verstärkers 3a bzw. 3b ist. Der zweite Pol der Schalter 23 und 24, der zweite Pol des Signaleingangs des Verstärkers 3a bzw. 3b, sowie der nichtinvertierende Eingang des Operationsverstärkers 20 liegen über je einen Widerstand oder, wie in der Fig. 10 dargestellt, direkt an Masse. Der Ausgang des astabilen Multivibrators 26 ist direkt mit dem Steuereingang der Schalter 23, 24 und 25 sowie über den Inverter 27 mit dem Steuereingang der Schalter 21 und 22 verbunden.

Der astabile Multivibrator 26 erzeugt ein rechteckförmiges Taktsignal, welches die Schalter 23 bis 25 einerseits und die Schalter 21 bis 22 anderseits in Gegentakt steuert, so dass jeweils nur immer in einer der beiden Gruppen die Schalter 23, 24 und 25 bzw. 21 und 22 geschlossen sind. Das Taktsignal oder die Steuersignale der beiden Schaltergruppen kann bzw. können natürlich statt intern auch extern erzeugt werden und über einen oder zwei getrennte, nicht dargestellte Takteingänge dem Verstärker 3a bzw. 3b zugeleitet werden. In diesen Fällen kann der astabile Multivibrator 26 und möglicherweise auch der Inverter 27 weggelassen werden.

In einer ersten Betriebsphase sind die Schalter 21 bis 22 offen und die Schalter 23 bis 25 geschlossen, so dass der Eingangskondensator Ci sich über die Schalter 23 bis 24 und der Rückkopplungskondensator Cf sich über den Schalter 25 jeweils auf Null Volt entladen kann. In einer zweiten Betriebsphase sind dagegen die Schalter 21 bis 22 geschlossen und die Schalter 23 bis 25 offen. Die Eingangsspannung des Verstärkers 3a bzw. 3b lädt dann über die geschlossenen Schalter 21 und 22 den Eingangskondensator Ci mit einem Ladestrom $i_C$, da der invertierende Eingang des Operationsverstärkers 20 bekanntlich virtuell an Masse liegt. Der Ladestrom $i_C$ fliesst weiter über den Rückkopplungskondensator Cf, in dem er einen Spannungsabfall verursacht, der gleich der Ausgangsspannung des Verstärkers 3a bzw. 3b ist. Der Verstärkungsfaktor des als invertierender Verstärker arbeitenden Vestärkers 3a bzw. 3b ist jeweils $[-(1/\Omega.Cf)-/(1/\Omega.Ci)] = (-Ci/Cf)$, wobei $\Omega$ die Umschaltfrequenz der Schalter 21 bis 25 ist.

Der Verstärkungsfaktor der Kaskadenschaltung 3a; 3b der beiden gleichaufgebauten Verstärker 3a und 3b, die beide je einen Verstärkungsfaktor (-Ci/Cf) besitzen, und damit des Verstärkers 3 ist somit gleich $(Ci/Cf)^2$, d. h. gleich dem Quadrat des Verhältnisses (Ci/Cf) der Kapazitätswerte der beiden Kondensatoren Ci und Cf.

In den beiden ersten Varianten (Fig. 1 und Fig. 2) ist der Eingangskondensator Ci in den beiden Verstärkern 3a und 3b jeweils ein Sperrschicht-Kondensator C1 und der Rückkopplungskondensator Cf ein Kondensator C2, der kein Sperrschicht-Kondensator, sondern ein konventioneller, z. B. mittels Polysilizium aufgebauter Kondensator ist, dessen Kapazität konstant und unabhängig von der Ladungsträgerkonzentration n ist. In der dritten Variante (Fig. 3) ist dagegen umgekehrt der Eingangskondensator Ci gleich dem Kondensator C2, der kein Sperrschicht-Kondensator ist, und der Rückkopplungskondensator Cf gleich dem Sperrschicht-Kondensator C1.

In den beiden ersten Varianten ist der Verstärker 3 somit eine Kaskadenschaltung von zwei mittels je eines Operationsverstärkers 20 aufgebauten invertierenden Verstärkern 3a und 3b, wobei jeweils der Ausgang und der invertierende Eingang des Operationsverstärkers 20 über den als Rückkopplungskondensator Cf dienenden zweiten Kondensator C2 miteinander verbunden sind, während ein erster Schalter 21, der als Eingangskondensator Ci dienende Sperrschicht-Kondensator C1 und ein zweiter Schalter 22 in der angegebenen Reihenfolge in Reihe geschaltet und zwischen einem Eingangspol des Verstärkers 3a bzw. 3b und dem invertierenden Eingang des zugehörigen Operationsverstärkers 20 angeordnet sind, und wobei die beiden Pole des Eingangskondensators Ci je über einen dritten bzw. vierten Schalter 23 bzw. 24 an Masse liegen und der Rückkopplungskondensator Cf durch einen fünften Schalter 25 überbrückt ist.

In der dritten Variante ist der Verstärker 3 auch eine Kaskadenschaltung von zwei mittels je eines Operationsverstärkers 20 aufgebauten invertierenden Verstärkern 3a und 3b, wobei jeweils der Ausgang und der invertierende Eingang des Operationsverstärkers 20 dagegen diesmal über den als Rückkopplungskondensator Cf dienenden Sperrschicht-Kondensator C1 miteinander verbunden sind, während ein erster Schalter 21, der als Eingangskondensator Ci dienende zweite Kondensator C2 und ein zweiter Schalter 22 diesmal in der angegebenen Reihenfolge in Reihe geschaltet und zwischen einem Eingangspol des Verstärkers 3a bzw. 3b und dem invertierenden Eingang des zugehörigen Operationsverstärkers 20 angeordnet sind, und wobei wieder die beiden Pole des Eingangskondensators Ci je über einen dritten bzw. vierten Schalter 23 bzw. 24 an Masse liegen und der Rückkopplungskondensator Cf durch einen fünften Schalter 25 überbrückt ist.

Das Quadrat des ursprünglichen Kapazitätswertes der gleichaufgebauten Sperrschicht-Kondensatoren C1 der beiden Verstärker 3a und 3b hat den Wert

$$C1^2(m) = K.m \qquad (VI),$$

mit m:     Ladungsträgerkonzentration (Dotierung) des aus N-dotiertem Halbleitermaterial bestehenden Kondensators C1,

$\beta$:     Dielektrizitätskonstante des Halbleitermaterials,

e:     Ladung eines Elektrons,

V:     Spannung über den Sperrschichtkondensator,

$V_{bi}$:     Eingebaute Spannung ("built-in voltage") von ca 0,6 Volt des Sperrschichtkondensators und

K:     $(e.\beta).(V_{bi}-V)/2$

Im Laufe der Zeit nimmt die Ladungsträgerkonzentration n des Magnetfeldsensors 1 wieder den Wert $n + \delta n$ und die Ladungsträgerkonzentration m der Sperrschicht-Kondensatoren C1 einen Wert $m + \delta m = m + \delta n$ an, mit $\delta m = \delta n$, so dass das Quadrat der Kapazität der Sperrschicht-Kondensatoren C1 folgenden neuen Wert annimmt (vergleiche mit Gleichung VI):

$$C1^2(m + \delta m) = K.(m + \delta n) = K.m.[1 + (n/m)(\delta n/n)]$$

Vorzugsweise wird die Ladungsträgerkonzentration m in den Sperrschicht-Kondensatoren C1 gleich gross gewählt wie die im Magnetfeldsensor 1 existierende Ladungsträgerkonzentration n, d. h. es gilt m = n.

Dann hat der Verstärkungsfaktor des Verstärkers 3 in den beiden ersten Varianten folgenden Wert:

$$(Ci/Cf)^2 = (C1/C2)^2 = (K.m./C2^2).(1 + \delta n/n)$$

Die nichtkompensierte Ausgangsspannung $u_H(n + \delta n)$ des Magnetfeldsensors 1 wird somit in den beiden ersten Varianten mit dem Verstärkungsfaktor des Verstärkers 3 und damit mit einem Korrekturfaktor multipliziert, der wieder proportional $(1 + \delta n/n)$ ist.

Die Eingangsspannung des Wandlers 4 (siehe Fig. 1 und Fig. 2) ist dann:

$$u_H(n + \delta n).(Ci/Cf)^2 =$$
$$[1/(1 + \delta n/n)]. u_H(n).(K.m/C2^2).(1 + \delta n/n) =$$
$$u_H(n).(K.m/C2^2),$$

und damit, wie angestrebt, unabhängig von der Änderung $\delta n$ der Ladungsträgerkonzentration $n$ im Magnetfeldsensor 1.

In der dritten Variante der erfindungsgemässen Anordnung hat dagegen der Verstärkungsfaktor des Verstärkers 3 dann einen Wert

$$(Ci/Cf)^2 = (C2/C1)^2 = (C2^2/K.m)/(1 + \delta n/n)$$

In der dritten Variante wird bekanntlich das Eingangssignal des Wandlers 4 durch die Ausgangsspannung $U_V$ des Verstärkers 3 geteilt. Dadurch wird dieses Eingangssignal auch hier mit einen Korrekturfaktor multipliziert, der proportional $(1 + \delta n/n)$ ist. Somit ist das Ausgangsnutzsignal des Wandlers 4 und damit das Ausgangsnutzsignal der erfindungsgemässen Anordnung wieder unabhängig von der Änderung $\delta n$ der Ladungsträgerkonzentration $n$ des Magnetfeldsensors 1.

Bezüglich des Aufbaus der Anordnung der Kondensatoren Ci und Cf sowie des Magnetfeldsensors 1 gelten prinzipiell die gleichen Regeln und die gleichen Bedingungen wie für den Aufbau der beiden Widerstände Ri und Rf sowie des Magnetfeldsensors 1. Insbesondere gilt auch die Figur 8 unter der Bedingung, dass die Widerstände Ri und Rf durch die Kondensatoren C1 der beiden Verstärker 3a und 3b ersetzt werden. Mindestens die Sperrschicht-Kondensatoren C1 sind somit nahe beim Magnetfeldsensor 1 in einem Halbleitermaterial eindiffundiert, welches vom gleichen Leitfähigkeitstyp N ist wie dasjenige, aus dem der Magnetfeldsensor 1 hergestellt ist. Einen vereinfachten Querschnitt durch einen möglichen Aufbau des Magnetfeldsensors 1 und von einem der Kondensatoren ist in der Fig. 11 dargestellt. Auf einem Substrat 14, welches z. B. aus schwach dotiertem P-Material besteht, ist eine Epitaxie-Schicht 15 aufgetragen, die z. B. aus schwach dotiertem N-Material besteht. In der Epitaxie-Schicht 15 sind der Magnetfeldsensor 1 und die Kondensatoren C1 angeordnet. Zwischen dem Magnetfeldsensor 1 und den Kondensatoren C1 sowie zwischen diesen Bauelementen und der benachbarten Epitaxie-Schicht 15 ist zur Isolation je eine Wanne 17, 18 oder 19 aus stark dotiertem P-Material in der Epitaxie-Schicht 15 eindiffundiert. Die Sperrschicht-Kondensatoren C1 bestehen aus einer stark dotierten P-Material-Schicht 28, die an der Oberfläche in der Epitaxie-Schicht 15 eindiffundiert ist. Aus der Fig. 11 sind auch die Anschlüsse I2, S1, I1, S2 und I3 des den Magnetfeldsensor 1 darstellenden vertikalen Hallelementes ersichtlich. Diese Anschlüsse bestehen alle aus je einer stark dotierten Diffusion aus N-Material, die an der Oberfläche in der Epitaxie-Schicht 15 eindiffundiert sind.

Die vierte Variante der erfindungsgemässen Anordnung ist ähnlich aufgebaut wie die dritte Variante mit dem Unterschied, dass der Verstärker 3 durch eine weitere Magnetfeldsensor-Schaltung 29 ersetzt ist (siehe Fig. 3). Die Magnetfeldsensor-Schaltung 29 ist das Korrekturglied der vierten Variante.

Die in der Fig. 12 dargestellte Magnetfeldsensor-Schaltung 29 enthält ihrerseits einen zweiten Magnetfeldsensor 1a, einen weiteren Spannungs/Strom-Wandler 2a und einen nur fakultativ vorhandenen Spannungsverstärker 30, wobei der Magnetfeldsensor 1a und der Spannungs/Strom-Wandler 2a ebenfalls vorzugsweise ein Hallelement bzw. ein Widerstand 10 ist ,und beide dann den in der Fig. 4 und der Fig. 5 dargestellten Aufbau besitzen.

Der als vertikales Hallelement angenommene Magnetfeldsensor 1a und der Spannungs/Strom-Wandler 2a sind untereinander so verbunden, wie der Magnetfeldsensor 1 mit dem Spannungs/Strom-Wandler 2 verbunden ist. Der Spannungseingang des Spannungs/Strom-Wandlers 2a ist zweipolig an einer konstanten Referenzspannung $U_R$ angeschlossen, während sein Stromausgang, der einen Ausgangsstrom $I_R$ liefert, der proportional der Referenzspannung $U_R$ ist, zweipolig mit dem Speisestromeingang I1; I2; I3 des Magnetfeldsensors 1a verbunden ist. Der Ausgang S1; S2 des Magnetfeldsensors 1a ist entweder auf den Eingang des fakultativ vorhandenen Spannungsverstärkers 30 oder direkt auf den Ausgang der Magnetfeldsensor-Schaltung 29 geführt. Der Ausgang des Spannungsverstärkers 30, falls vorhanden, bildet den Ausgang der Magnetfeldsensor-Schaltung 29. Der zweite Pol S2 des Ausganges S1; S2 des Magnetfeldsensors 1a kann wieder entweder virtuell oder direkt an Masse liegen.

Wie aus der Fig. 3 ersichtlich, ist der Ausgang der Magnetfeldsensor-Schaltung 29 und damit auch der Ausgang des zweiten Magnetfeldsensors 1a mit dem Referenzspannungseingang 5; 6 des Wandlers 4 verbunden, dessen Ausgang wieder den Ausgang der erfindungsgemässen Anordnung bildet. Der Aufbau und die Funktion der vierten Variante ist ähnlich dem Aufbau und der Funktion der dritten Variante, mit dem Unterschied, dass diesmal die Eingangsspannung des Wandlers 4 nicht durch die Ausgangsspannung des Verstärkers 3, sondern durch die, möglicherweise verstärkte, Ausgangsspannung des zweiten Magnetfeldsensors 1a geteilt wird.

Der Magnetfeldsensor 1 ist wieder der zu messenden Magnetfeldinduktion $B_N$ ausgesetzt, die, wie bereits erwähnt, vom Netzstrom $i_N$ erzeugt wird. Der Magnetfeldsensor 1a ist dagegen einer Magnetfeldinduktion $B_0$ ausgesetzt, die entweder konstant oder mit konstanter Amplitude sinusförmig ist. Im ersten Fall ist die Referenzspannung $U_R$ konstant und die Magnetfeldinduktion $B_0$ wird durch einen nicht dargestellten Permanentmagneten oder durch eine nicht dargestellte, von einem konstanten Gleichstrom durchflossene Spule erzeugt. Im zweiten Fall muss dagegen auch die Referenzspannung $U_R$ mit konstanter Amplitude sinusförmig sein, wobei $B_0$ und $U_R$ eine gleiche Frequenz aufweisen müssen.

Die beiden Magnetfeldsensoren 1 und 1a werden wieder aus einem gleichen Halbleitermaterial, z. B. aus N-dotiertem Material, und elektrisch voneinander isoliert, auf einem gleichen Substrat, mit annähernd gleichen Abmessungen sowie mit möglichst identischen Eigenschaften, insbesondere mit gleichen Ladungsträger-Dotierungen und mit vorzugsweise gleichen Abmessungen, hergestellt. Die Geometrien der beiden Magnetfeldsensoren 1 und 1a können in der Praxis höchst identisch realisiert werden, so dass ihr Verhältnis langzeitstabil ziemlich genau gleich eins ist.

Es gelten für die beiden Magnetfeldsensoren 1 und 1a folgende Gleichungen:

$$u_H(n) = (k/n).i.B_N$$
$$\text{und } U_{H,0}(n) = (k/n).I_R.B_0,$$

wobei $I_R$ den Speisestrom des Magnetfeldsensors 1a bezeichnet.

Die Ausgangsspannung $U_V$ des Spannungsverstärkers 30 ist dann $U_V = v.U_{H,0}$, wenn v den Verstärkungsfaktor des Spannungsverstärkers 30 bezeichnet.

Das Ausgangsnutzsignal des Wandlers 4, nämlich der digitale Ausgangswert der Ausgangsspannung $u_A$ des Analog/Digital-Wandlers bzw. die Ausgangsfrequenz $f_A$ des Spannungs/Frequenz-Wandlers, und damit das Ausgangsnutzsignal der erfindungsgemässen Anordnung ist dann unter Verwendung eines Proportionalitätsfaktors M gleich:

$$M.[U_H/U_V] = M.[u_H/(v.U_{H,0})] =$$
$$M.[(k/n).i.B_N]/[v.(k/n).I_R.B_0] =$$
$$M.[i.B_N]/[v.I_R.B_0],$$

d. h. das Ausgangsnutzsignal ist wieder unabhängig von der Änderung $\delta n$ der Ladungsträgerkonzentration n. Wenn sich somit im Laufe der Zeit die Ladungsträgerkonzentration des Magnetfeldsensors 1 von n auf $n + \delta n$ ändert, dann ändert sich auch die Ladungsträgerkonzentration des zweiten Magnetfeldsensors 1a von n auf $n + \delta n$, so dass das Ausgangsnutzsignal der Anordnung unabhängig von der Änderung $\delta n$ der Ladungsträgerkonzentration n der Magnetfeldsensoren 1 und 1a bleibt.

Damit die beiden Magnetfeldsensoren 1 und 1a einer gleichen Änderung $\delta n$ unterliegen, müssen sie möglichst nahe beieinander im Halbleitermaterial angeordnet sein, so dass sie eine gleiche Temperatur annehmen. Ausserdem sind sie mit gleichen Tiefen und in einer gleicher Technologie, d. h. mit gleichen Prozessschritten, im empfindlichen Volumen der Hallelemente herzustellen.

Im Querschnitt der Fig. 11 ist der Kondensator C1 durch den Magnetfeldsensor 1a zu ersetzen. Die beiden Magnetfeldsensoren 1 und 1a sind dann parallel in einem N-dotiertem Material angeordnet. In einer weiteren bevorzugten, nicht dargestellten Ausführung werden die beiden Magnetfeldsensoren 1 und 1a, um magnetisch entkoppelt zu sein, räumlich um 90° gegeneinander gedreht angeordnet.

Die in der Fig. 13 dargestellte fünfte Variante der erfindungsgemässen Anordnung besteht aus dem Spannungs/Strom-Wandler 2, einem Impedanzwandler 31, dem Magnetfeldsensor 1 und dem Wandler 4, die in der angegebenen Reihenfolge in Kaskade geschaltet sind. Am Referenzspannungseingang 5; 6 des Wandlers 4 steht wieder eine konstante Referenzspannung $U_0$ und am Referenzfrequenzeingang 7 eine konstante Referenzfrequenz $f_0$ an. Der Impedanzwandler 31 besteht gemäss Fig. 14 aus einem Spannungsfolger 32 und einem vorgeschalteten Widerstand R. Der Widerstand R ist nahe beim Magnetfeldsensor 1 in einem Halbleitermaterial eindiffundiert, welches vom gleichen Materialleitfähigkeitstyp N ist wie dasjenige, aus dem der Magnetfeldsensor 1 hergestellt ist. Der Spannungsfolger 32 besteht aus einem Operationsverstärker 33, dessen invertierender Eingang direkt mit dem Ausgang des Operationsverstärkers 33 verbunden ist und dessen nichtinvertierender Eingang einen ersten Eingangspol des Impedanzwandlers 31 bildet und gleichzeitig mit einem ersten Pol des Widerstandes R verbunden ist, während der Ausgang des Operationsverstärkers 33 gleichzeitig ein erster Ausgangspol des Impedanzwandlers 31 ist. Ein zweiter Eingangspol des Impedanzwandlers 31 ist innerhalb desselben auf einen zweiten Pol des Widerstandes R geführt und bildet gleichzeitig einen zweiten Ausgangspol des Impedanzwandlers 31. Die Netzspannung $u_N$ ist zweipolig mit dem Spannungseingang des Spannungs/Strom-Wandlers 2 verbunden, dessen Stromausgang zweipolig auf den Eingang des Impedanzwandlers 31 geführt ist, während der Ausgang des letzten zweipolig mit dem Speisestromeingang I1; I2; I3 des Magnetfeldsensors 1 verbunden ist. Der Widerstand R ist somit mit Hilfe des Spannungsfolgers 32 zweipolig mit dem Speisestromeingang I1; I2; I3 des Magnetfeldsensors 1 verbunden. Der Sensorausgang S1; S2 des Magnetfeldsensors 1 ist zweipolig auf den Signaleingang des Wandlers 4 geführt, wobei der Sensor-Ausgangspol S2 virtuell oder direkt an Masse liegen kann. Der Ausgang des Wandlers 4 bildet den Ausgang der erfindungsgemässen Anordnung. Der Magnetfeldsensor 1 ist wieder der Magnetfeldinduktion $B_N$ ausgesetzt. Der Widerstand R ist im gleichen, z. B. N-dotierten Material eindiffundiert wie der Magnetfeldsensor 1 und z. B. anstelle des Kondensators C1 im Aufbau angeordnet, der in der Fig. 11 dargestellt ist.

Die Netzspannung $u_N$ wird durch den Spannungs/Strom-Wandler 2 in einen proportionalen Strom i umgewandelt, der den Widerstand R speist und in ihm einen Spannungsabfall $V = R.i$ erzeugt, der durch den Spannungsfolger 32 um einen Faktor Eins verstärkt am Stromeingang I1; I2; I3 des Magnetfeldsensors 1 ansteht, in dem er einen Speisestrom I verursacht, der gleich $V/R_E$ ist, wobei $R_E$ den Eingangswiderstand des Stromeinganges I1; I2; I3 des Magnetfeldsensors 1 bezeichnet. Dabei gilt:

$$I = (R/R_E).i \qquad (VIII)$$

Ohne das Vorhandensein des eindiffundierten Widerstandes R und des Spannungsfolgers 32, deren Kombination zusammen als Korrekturglied und Impedanzwandler 31 wirksam ist, würde der Magnetfeldsensor 1 direkt mit dem Strom i gespeist und seine nicht kompensierte Ausgangsspannung wäre dann:

$$u_{H,nk}(n) = (k/n).B_N.i$$

Durch das Vorhandensein des Impedanzwandlers 31 als Korrekturglied ist unter Berücksichtigung der Gleichung (VIII) die jetzt kompensierte Ausgangsspannung des Magnetfeldsensors 1 gleich:

$$
\begin{aligned}
u_{H,k}(n) &= (k/n).B_N.I \\
&= (k/n).B_N.i.(R/R_E) \\
&= u_{H,nk}(n).(R/R_E) \qquad\qquad (IX),
\end{aligned}
$$

wobei die Widerstände R und $R_E$ als eindiffundierte Widerstände gemäss Gleichung II folgende Werte besitzen:

$$R = A/m$$

und

$$R_E = A_E/n$$

Dabei bezeichnet n die Ladungsträgerkonzentration des Magnetfeldsensors 1, $m = p.n$ die relativ hohe Ladungsträgerkonzentration des Widerstandes R, da für p ein grosser Wert zu wählen ist, A den Proportionalitätsfaktor des Widerstandes R und $A_E$ den Proportionalitätsfaktor des Eingangswiderstandes $R_E$. Der Wert von p ist mindestens annähernd gleich fünf zu wählen, so dass die Ladungsträgerkonzentra- tion m des eindiffundierten Widerstandes R annähernd mindestens fünffach so hoch ist wie diejenige des Magnetfeldsensors 1.

Es gilt somit:

$$(R/R_E) = (A/A_E).(n/m) = D.(n/m)$$

mit $D = (A/A_E)$.

Wenn die Ladungsträgerkonzentrationen n und m im Laufe der Zeit wieder die Werte $n + \delta n$ bzw. $m + \delta m = m + \delta n$ annehmen, mit $\delta n = \delta m$, dann ergibt sich folgendes Widerstandsverhältnis:

$(R/R_E) = D.[(n + \delta n)/(p.n + \delta n)$.

Da der Wert von p, wie bereits erwähnt, relativ gross gewählt wird, kann $\delta n$ gegenüber p.n vernachlässigt werden, so dass das Widerstandsverhältnis annähernd folgenden Wert annimmt:

$(R/R_E) = (D/p).(1 + \delta n/n)$.

Die Gleichung IX ergibt dann:

$u_{H,k}(n + \delta n) = (D/p).(1 + \delta n/n).u_{H,nk}(n + \delta n)$

Der Impedanzwandler 31 ist somit als Korrekturglied in einem Speisestrom-Eingangskreis 31; 2 des Magnetfeldsensors 1 derartig angeordnet, dass der Speisestrom i der Anordnung sowie die nicht kompensierte Ausgangsspannung $u_{H,nk}$ des Magnetfeldsensors 1 je mit einem Faktor multipliziert werden, der proportional dem Faktor $(1 + \delta n/n)$ ist. Die Verwendung des Korrekturgliedes führt somit wie angestrebt dazu, dass die nichtkompensierte Ausgangsspannung $u_{H,nk}$ des Magnetfeldsensors 1 mit einem Faktor multipliziert wird, der proportional $(1 + \delta n/n)$ ist.

Durch die zeitliche Änderung $\delta n$ der Ladungsträgerkonzentrationen n und m ist die kompensierte Ausgangsspannung des Magnetfeldsensors 1 ausserdem gleich:

$$\begin{aligned}
u_{H,k}(n+\delta n) &= (D/p).(1+\delta n/n).[k/(n+\delta n)].B_N.i \\
&= (D/p).(1+\delta n/n).(k/n)[1/(1+\delta n/n)].B_N.i \\
&= (D/p).(k/n).B_N.i \\
&= (D/p).u_{H,nk}(n)
\end{aligned}$$

Die kompensierte Ausgangsspannung $u_{H,k}$ des Magnetfeldsensors 1 ist somit unabhängig von der Änderung $\delta n$ der Ladungsträgerkonzentration n im Magnetfeldsensor 1.

Bezüglich Aufbau der Anordnung des Widerstandes R und des Magnetfeldsensors 1 in der fünften Variante gelten prinzipiell die gleichen Regeln und die gleichen Bedingungen wie für den Aufbau der beiden Magnetfeldsensoren 1 und 1a der vierten Variante.

Wenn der Wandler 4 ein Spannungs/Frequenz-Wandler ist, dann ist, wie bereits erwähnt, das Uebertragungsverhältnis des Wandlers 4, welches eine Dimension 1/(Sekunde.Volt) besitzt, auch proportional einer Referenzfrequenz $f_O$, d. h. das Eingangssignal des Wandlers 4 wird in demselben mit dieser Referenzfrequenz $f_O$ multipliziert zwecks Erzeugung von dessen Nutzsignal. Genau wie in der dritten und vierten Variante die Spannung am Referenzspannungseingang 5; 6 des Wandlers 4 benutzt wird zur Verwirklichung der Teilung des Eingangssignals des Wandlers 4 durch einen Faktor, der proportional dem Faktor $(1-\delta n/n)$ ist, bzw. zur Realisierung der Multiplikation dieses Eingangssignals mit einem Faktor, der proportional $(1 + \delta n/n)$ ist, so kann auch die Referenzfrequenz $f_O$ des Wandlers 4 in weiteren, nicht beschriebenen Varianten dazu benutzt werden, um dieses Eingangssignal mit einen Faktor $(1 + \delta n/n)$ zu multiplizieren. Die Referenzfrequenz $f_O$ ist dann nicht mehr konstant, sondern muss dann proportional diesem Faktor erzeugt werden mit Hilfe eines Oszillators, dessen Frequenz entsprechend abhängig vom Wert eines Verhältnisses R1/R2 zweier Widerstände R1 und R2 oder eines Sperrschicht-Kondensators C1 generiert wird. Die Referenzspannung $U_O$ des Wandlers 4 ist in diesem Fall in der Regel konstant.

**Patentansprüche**

1. Integrierte Halbleiterschaltung mit einem Magnetfeldsensor (1) aus Halbleitermaterial, dessen Ausgangsspannung $(u_H)$ umgekehrt proportional zur Ladungsträgerkonzentration (n) im Halbleitermaterial ist, einem Ausgangsnutzsignal $(u_A, f_A)$, welches der Ausgangsspannung $(u_H)$ des Magnetfeldsensors (1) proportional ist, und einem Verstärker (3) als Korrekturglied, der mit Widerständen (R1, R2) versehen ist, die in demselben Halbleitermaterial eindiffundiert sind, aus dem der Magnetfeldsensor (1) hergestellt ist, und dessen Verstärkungsfaktor der Kompensation von Empfindlichkeitsänderungen des Magnetfeldsensors (1) dient, dadurch gekennzeichnet, dass, zur Verbesserung der Langzeitstabilität des Magnetfeldsensors (1), am Eingang des Verstärkers (3) eine konstante Referenzspannung ($U_R$) liegt und der Ausgang des Verstärkers (3) mit einem ersten Eingang eines Multiplizierers (8) verbunden ist, dessen zweiter Eingang an einer Netzspannung ($u_N$) liegt und dessen Ausgang über einen Spannungs/Strom-Wandler (2) mit dem Speisestromeingang (I1;I2;I3) des Magnetfeldsensors (1) verbunden ist, der Verstärkungsfaktor des Verstärkers (3) proportional dem Verhältnis (R1/R2) der Widerstandswerte eines ersten zu einem zweiten Widerstand (R1 bzw. R2) des Verstärkers (3) ist, die Ladungsträgerkonzentration (m1) im ersten Widerstand (R1) gleich gross ist wie die im Magnetfeldsensor (1) existierende Ladungsträgerkonzentration (n) und die Ladungsträgerkonzentration (m2) im zweiten Widerstand (R2) gleich der halben Ladungsträgerkonzentration (n/2) der im ersten Widerstand (R1) existierenden Ladungsträgerkonzentration (m1 = n) ist, beide Widerstände (R1, R2) annähernd gleiche Abmessungen wie der Magnetfeldsensor (1) aufweisen und nahe beim Magnetfeldsensor (1) im Halbleitermaterial eindiffundiert sind, so dass die zeitlichen Änderungen ($\delta n$, $\delta m1$, $\delta m2$) der Ladungsträgerkonzentrationen (n, m1, m2) des Magnetfeldsensors (1) und der Widerstände (R1, R2) gleich gross sind, wodurch eine zeitliche Änderung $\delta n$ der Ladungsträgerkonzentrationn im Magnetfeldsensor (1) durch Multiplikation des Speisestromes (i) des Magnetfeldsensors (1) mit einem Korrekturfaktor, der proportional zum Faktor 1 + $\delta n/n$ ist, im Verstärker (3) kompensiert wird.

2. Integrierte Halbleiterschaltung mit einem Magnetfeldsensor (1) aus Halbleitermaterial, dessen Ausgangsspannung ($u_H$) umgekehrt proportional zur Ladungsträgerkonzentration (n) im Halbleitermaterial ist, einem Ausgangsnutzsignal ($u_A$, $f_A$), welches der Ausgangsspannung ($u_H$) des Magnetfeldsensors (1) proportional ist, und einem Verstärker (3) als Korrekturglied, dessen Verstärkungsfaktor der Kompensation von Empfindlichkeitsänderungen des Magnetfeldsensors (1) dient, dadurch gekennzeichnet, dass, zur Verbesserung der Langzeitstabilität des Magnetfeldsensors (1), am Eingang des Verstärkers (3) eine konstante Referenzspannung ($U_R$) liegt und der Ausgang des Verstärkers (3) mit einem ersten Eingang eines Multiplizierers (8) verbunden ist, dessen zweiter Eingang an einer Netzspannung ($u_N$) liegt und dessen Ausgang über einen Spannungs/Strom-Wandler (2) mit dem Speisestromeingang (I1;I2;I3) des Magnetfeldsensors (1) verbunden ist, der Verstärkungsfaktor des Verstärkers (3) proportional dem Quadrat des Verhältnisses (C1/C2) der Kapazitätswerte eines Sperrschicht-Kondensators (C1) zu einem zweiten Kondensator (C2) des Verstärkers (3) ist, wobei der zweite Kondensator (C2) kein Sperrschicht-Kondensator ist und eine konstante, von der Ladungsträgerkonzentration unabhängige Kapazität aufweist, die Ladungsträgerkonzentration (m) im Sperrschicht-Kondensator (C1) gleich gross ist wie die im Magnetfeldsensor (1) existierende Ladungsträgerkonzentration (n) und der Sperrschicht-Kondensator (C1) nahe beim Magnetfeldsensor (1) im Halbleitermaterial eindiffundiert ist, so dass die zeitlichen Änderungen ($\delta n$, $\delta m$) der Ladungsträgerkonzentrationen (n, m) des Magnetfeldsensors (1) und des Sperrschicht-Kondensators (C1) gleich gross sind, wodurch eine zeitliche Änderung $\delta n$ der Ladungsträgerkonzentration n im Magnetfeldsensor (1) durch Multiplikation des Speisestromes (i) des Magnetfeldsensors (1) mit einem Korrekturfaktor, der proportional zum Faktor 1 + $\delta n/n$ ist, im Verstärker (3) kompensiert wird.

3. Integrierte Halbleiterschaltung mit einem Magnetfeldsensor (1) aus Halbleitermaterial, dessen Ausgangsspannung ($u_H$) umgekehrt proportional zur Ladungsträgerkonzentration (n) im Halbleitermaterial ist, einem Ausgangsnutzsignal ($u_A$, $f_A$), welches der Ausgangsspannung ($u_H$) des Magnetfeldsensors (1) proportional ist, und einem dem Magnetfeldsensor (1) als Korrekturglied in Serie nachgeschalteten Verstärker (3), der mit Widerständen (R1, R2) versehen ist, die in demselben Halbleitermaterial eindiffundiert sind, aus dem der Magnetfeldsensor (1) hergestellt ist, und dessen Verstärkungsfaktor der Kompensation von Empfindlichkeitsänderungen des Magnetfeldsensors (1) dient, dadurch gekennzeichnet, dass, zur Verbesserung der Langzeitstabilität des Magnetfeldsensors (1), der Verstärkungsfaktor des Verstärkers (3) proportional dem Verhältnis (R1/R2) der Widerstandswerte eines ersten zu einem zweiten Widerstand (R1 bzw. R2) des Verstärkers (3) ist, die Ladungsträgerkonzentration (m1) im ersten Widerstand (R1) gleich gross ist wie die im Magnetfeldsensor (1) existierende Ladungsträgerkonzentration (n) und die Ladungsträgerkonzentration (m2) im zweiten Widerstand (R2) gleich der halben Ladungsträgerkonzentration (n/2) der im ersten Widerstand (R1) existierenden Ladungsträgerkonzentration (m1 = n) ist, beide Widerstände (R1, R2) annähernd gleiche Abmessungen wie der Magnetfeldsensor (1) aufweisen und nahe beim Magnetfeldsensor (1) im Halbleitermaterial eindiffundiert sind, so dass die zeitlichen Änderungen ($\delta n$, $\delta m1$, $\delta m2$) der Ladungsträgerkonzentrationen (n, m1, m2) des Magnetfeldsensors (1) und der Widerstände (R1, R2) gleich gross sind, wodurch eine zeitliche Änderung $\delta n$ der Ladungsträgerkonzentration n im Magnetfeldsensor (1) durch Multiplikation der Ausgangsspannung ($u_H$) des Magnetfeldsensors (1) mit einem Korrekturfaktor, der proportional zum Faktor 1 + $\delta n/n$ ist, im Verstärker (3) kompensiert wird.

4.  Integrierte Halbleiterschaltung mit einem Magnetfeldsensor (1) aus Halbleitermaterial, dessen Ausgangsspannung ($u_H$) umgekehrt proportional zur Ladungsträgerkonzentration (n) im Halbleitermaterial ist, einem Ausgangsnutzsignal ($u_A$, $f_A$), welches der Ausgangsspannung ($u_H$) des Magnetfeldsensors (1) proportional ist, und einem dem Magnetfeldsensor (1) als Korrekturglied in Serie nachgeschalteten Verstärker (3), dessen Verstärkungsfaktor der Kompensation von Empfindlichkeitsänderungen des Magnetfeldsensors (1) dient, dadurch gekennzeichnet, dass, zur Verbesserung der Langzeitstabilität des Magnetfeldsensors (1), der Verstärkungsfaktor des Verstärkers (3) proportional dem Quadrat des Verhältnisses (C1/C2) der Kapazitätswerte eines Sperrschicht-Kondensators (C1) zu einem zweiten Kondensator (C2) des Verstärkers (3) ist, wobei der zweite Kondensator (C2) kein Sperrschicht-Kondensator ist und eine konstante, von der Ladungsträgerkonzentration unabhängige Kapazität aufweist, die Ladungsträgerkonzentration (m) im Sperrschicht-Kondensator (C1) gleich gross ist wie die im Magnetfeldsensor (1) existierende Ladungsträgerkonzentration (n) und der Sperrschicht-Kondensator (C1) nahe beim Magnetfeldsensor (1) im Halbleitermaterial eindiffundiert ist, so dass die zeitlichen Änderungen ($\delta n$, $\delta m$) der Ladungsträgerkonzentrationen (n, m) des Magnetfeldsensors (1) und des Sperrschicht-Kondensators (C1) gleich gross sind, wodurch eine zeitliche Änderung $\delta n$ der Ladungsträgerkonzentration n im Magnetfeldsensor (1) durch Multiplikation der Ausgangsspannung ($u_H$) des Magnetfeldsensors (1) mit einem Korrekturfaktor, der proportional zum Faktor 1 + $\delta n/n$ ist, im Verstärker (3) kompensiert wird.

5.  Integrierte Halbleiterschaltung mit einem Magnetfeldsensor (1) aus Halbleitermaterial, dessen Ausgangsspannung ($u_H$) umgekehrt proportional zur Ladungsträgerkonzentration (n) im Halbleitermaterial ist, einem Ausgangsnutzsignal ($u_A$, $f_A$), welches der Ausgangsspannung ($u_H$) des Magnetfeldsensors (1) proportional ist, und einem Verstärker (3) als Korrekturglied, der mit Widerständen (R1, R2) versehen ist, die in demselben Halbleitermaterial eindiffundiert sind, aus dem der Magnetfeldsensor (1) hergestellt ist, und dessen Verstärkungsfaktor der Kompensation von Empfindlichkeitsänderungen des Magnetfeldsensors (1) dient, dadurch gekennzeichnet, dass, zur Verbesserung der Langzeitstabilität des Magnetfeldsensors (1), dem Magnetfeldsensor (1) ein Wandler (4) in Serie nachgeschaltet ist, der Wandler (4) einen Referenzspannungseingang (5;6) aufweist, der mit dem Ausgang des Verstärkers (3) verbunden ist, die Ausgangsspannung ($u_H$) des Magnetfeldsensors (1) im Wandler (4) durch die Ausgangsspannung ($U_V$) des Verstärkers (3) geteilt wird, der Verstärker (3) eine konstante Referenzspannung ($U_R$) als Eingangsspannung aufweist, der Verstärkungsfaktor des Verstärkers (3) proportional dem Verhältnis (R2/R1) der Widerstandswerte eines zweiten zu einem ersten Widerstand (R2 bzw. R1) des Verstärkers (3) ist, die Ladungsträgerkonzentration (m1) im ersten Widerstand (R1) gleich gross ist wie die im Magnetfeldsensor (1) existierende Ladungsträgerkonzentration (n) und die Ladungsträgerkonzentration (m2) im zweiten Widerstand (R2) gleich der halben Ladungsträgerkonzentration (n/2) der im ersten Widerstand (R1) existierenden Ladungsträgerkonzentration (m1 = n) ist, beide Widerstände (R1, R2) annähernd gleiche Abmessungen wie der Magnetfeldsensor (1) aufweisen und nahe beim Magnetfeldsensor (1) im Halbleitermaterial eindiffundiert sind, so dass die zeitlichen Änderungen ($\delta n$, $\delta m1$, $\delta m2$) der Ladungsträgerkonzentrationen (n, m1, m2) des Magnetfeldsensors (1) und der Widerstände (R1, R2) gleich gross sind, wodurch eine zeitliche Änderung $\delta n$ der Ladungsträgerkonzentration n im Magnetfeldsensor (1) durch Multiplikation der Ausgangsspannung ($u_H$) des Magnetfeldsensors (1) mit einem Korrekturfaktor, der proportional zum Faktor 1 + $\delta n/n$ ist, im Wandler (4) kompensiert wird.

6.  Integrierte Halbleiterschaltung mit einem Magnetfeldsensor (1) aus Halbleitermaterial, dessen Ausgangsspannung ($u_H$) umgekehrt proportional zur Ladungsträgerkonzentration (n) im Halbleitermaterial ist, einem Ausgangsnutzsignal ($u_A$, $f_A$), welches der Ausgangsspannung ($u_H$) des Magnetfeldsensors (1) proportional ist, und einem Verstärker (3) als Korrekturglied, dessen Verstärkungsfaktor der Kompensation von Empfindlichkeitsänderungen des Magnetfeldsensors (1) dient, dadurch gekennzeichnet, dass, zur Verbesserung der Langzeitstabilität des Magnetfeldsensors (1), dem Magnetfeldsensor (1) ein Wandler (4) in Serie nachgeschaltet ist, der Wandler (4) einen Referenzspannungseingang (5;6) aufweist, der mit dem Ausgang des Verstärkers (3) verbunden ist, die Ausgangsspannung ($u_H$) des Magnetfeldsensors (1) im Wandler (4) durch die Ausgangsspannung ($U_V$) des Verstärkers (3) geteilt wird, der Verstärker (3) eine konstante Referenzspannung ($U_R$) als Eingangsspannung aufweist, der Verstärkungsfaktor des Verstärkers (3) proportional dem Quadrat des Verhältnisses (C1/C2) der Kapazitätswerte eines Sperrschicht-Kondensators (C1) zu einem zweiten Kondensator (C2) des Verstärkers (3) ist, wobei der zweite Kondensator (C2) kein Sperrschicht-Kondensator ist und eine konstante, von der Ladungsträgerkonzentration unabhängige Kapazität aufweist, die Ladungsträgerkonzentration (m) im Sperrschicht-Kondensator (C1) gleich gross ist wie die im Magnetfeldsensor (1) existierende Ladungsträgerkonzentration (n) und der Sperrschicht-Kondensator (C1) nahe beim Magnetfeldsensor (1) im Halbleitermaterial eindiffundiert ist, so dass die zeitlichen Änderungen ($\delta n$, $\delta m$) der Ladungsträgerkonzentrationen (n, m) des Magnetfeldsensors (1) und des Sperrschicht-Kondensators (C1) gleich gross sind, wodurch eine zeitliche Änderung $\delta n$ der Ladungsträgerkonzentration n im Magnetfeldsensor (1) durch Multiplikation der Ausgangsspannung ($u_H$) des Magnetfeldsensors (1) mit einem Korrekturfaktor, der proportional zum Faktor $1 + \delta n/n$ ist, im Wandler (4) kompensiert wird.

7.  Integrierte Halbleiterschaltung mit einem ersten Magnetfeldsensor (1) aus Halbleitermaterial, dessen Ausgangsspannung ($u_H$) umgekehrt proportional zur Ladungsträgerkonzentration (n) im Halbleitermaterial ist, und einem Ausgangsnutzsignal ($u_A$, $f_A$), welches der Ausgangsspannung ($u_H$) des ersten Magnetfeldsensors (1) proportional ist, dadurch gekennzeichnet, dass, zur Verbesserung der Langzeitstabilität des ersten Magnetfeldsensors (1), eine einen zweiten Magnetfeldsensor (1a) als Korrekturglied enthaltende weitere Magnetfeldsensor-Schaltung (29) vorhanden ist, dem ersten Magnetfeldsensor (1) ein Wandler (4) in Serie nachgeschaltet ist, der Wandler (4) einen Referenzspannungseingang (5;6) aufweist, der mit dem Ausgang der weiteren Magnetfeldsensor-Schaltung (29) verbunden ist, die Ausgangsspannung ($u_H$) des ersten Magnetfeldsensors (1) im Wandler (4) durch die Ausgangsspannung ($U_V$) der weiteren Magnetfeldsensor-Schaltung (29) geteilt wird, die weitere Magnetfeldsensor-Schaltung (29) eine konstante Referenzspannung ($U_R$) als Eingangsspannung aufweist, die Ladungsträgerkonzentrationen (n) in den beiden Magnetfeldsensoren (1, 1a) gleich gross sind, beide Magnetfeldsensoren (1, 1a) annähernd gleiche Abmessungen aufweisen und nahe beieinander im Halbleitermaterial angeordnet sind, so dass die zeitlichen Änderungen ($\delta n$) der Ladungsträgerkonzentrationen (n) der beiden Magnetfeldsensoren (1, 1a) gleich gross sind, wodurch eine zeitliche Änderung $\delta n$ der Ladungsträgerkonzentration n im ersten Magnetfeldsensor (1) durch Multiplikation der Ausgangsspannung ($u_H$) des ersten Magnetfeldsensors (1) mit einem Korrekturfaktor, der proportional zum Faktor $1 + \delta n/n$ ist, im Wandler (4) kompensiert wird.

8.  Integrierte Halbleiterschaltung mit einem Magnetfeldsensor (1) aus Halbleitermaterial, dessen Ausgangsspannung ($u_H$) umgekehrt proportional zur Ladungsträgerkonzentration (n) im Halbleitermaterial ist, einem Ausgangsnutzsignal ($u_A$, $f_A$), welches der Ausgangsspannung ($u_H$) des Magnetfeldsensors (1) proportional ist, und einem dem Magnetfeldsensor (1) als Korrekturglied in Serie vorgeschalteten Impedanzwandler (31), der einen Widerstand (R) aufweist, der in demselben Halbleitermaterial eindiffundiert ist, aus dem der Magnetfeldsensor (1) hergestellt ist, und der der Kompensation von Empfindlichkeitsänderungen des Magnetfeldsensors (1) dient, dadurch gekennzeichnet, dass, zur Verbesserung der Langzeitstabilität des Magnetfeldsensors (1), der Impedanzwandler (31) einen Spannungsfolger (32) enthält, der Widerstand (R) des Impedanzwandlers (31) über den Spannungsfolger (32) zweipolig mit dem Speisestrom-Eingang (I1;I2;I3) des Magnetfeldsensors (1) verbunden ist, der Impedanzwandler (31) von einem Spannungs/Strom-Wandler (2) mit einem Strom (i) gespeist ist, die Ladungsträgerkonzentration (m) im Widerstand (R) des Impedanzwandlers (31) annähernd mindestens fünffach so hoch ist wie diejenige des Magnetfeldsensors (1), der Widerstand (R) des Impedanzwandlers (31) nahe beim Magnetfeldsensor (1) im Halbleitermaterial eindiffundiert ist, so dass die zeitlichen Änderungen ($\delta n$, $\delta m$) der Ladungsträgerkonzentrationen (n, m) des Magnetfeldsensors (1) und des Widerstandes (R) des Impedanzwandlers (31) gleich gross sind, wodurch eine zeitliche Änderung $\delta n$ der Ladungsträgerkonzentration n im Magnetfeldsensor (1) durch Multiplikation der Ausgangsspannung ($u_H$) des Magnetfeldsensors (1) mit einem Korrekturfaktor, der proportional zum Faktor $1 + \delta n/n$ ist, im Impedanzwandler (31) kompensiert wird.

9.  Integrierte Halbleiterschaltung nach einem der Ansprüche 1, 3 oder 5, dadurch gekennzeichnet, dass der Verstärker (3) aus einem mittels eines Operationsverstärkers (11) aufgebauten invertierenden Verstärker besteht, wobei einer der beiden Widerstände (R1 bzw. R2) als Rückkopplungswiderstand (Rf) zwischen dem Ausgang des Operationsverstärkers (11) und dessem invertierenden Eingang angeordnet ist, während der andere der beiden Widerstände (R2 bzw. R1) als Eingangswiderstand (Ri) dem invertierenden Eingang des Operationsverstärkers (11) vorgeschaltet ist.

**10.** Integrierte Halbleiterschaltung nach einem der Ansprüche 1, 3 oder 5, dadurch gekennzeichnet, dass der Verstärker (3) aus einer Serienschaltung von zwei mit Hilfe je eines Operationsverstärkers (12a;13a) aufgebauten invertierenden Verstärkern (12;13) besteht, wobei der eine der beiden Widerstände (R1 bzw. R2) als Rückkopplungswiderstand (Rf) zwischen dem Ausgang des Operationsverstärkers (12a) des vorderen invertierenden Verstärkers (12) und dem invertierenden Eingang dieses Operationsverstärkers (12a) angeordnet ist, während der andere der beiden Widerstände (R2 bzw. R1) als Eingangswiderstand (Ri) dem invertierenden Eingang des Operationsverstärkers (13a) des hinteren invertierenden Verstärkers (13) vorgeschaltet ist, und wobei ein dritter Widerstand (R3) dem invertierenden Eingang des Operationsverstärkers (12a) des vorderen invertierenden Verstärkers (12) als Eingangswiderstand vorgeschaltet ist, während ein vierter Widerstand (R4) als Rückkopplungswiderstand zwischen dem Ausgang des Operationsverstärkers (13a) des hinteren invertierenden Verstärkers (13) und dem invertierenden Eingang dieses Operationsverstärkers (13a) angeordnet ist.

**11.** Integrierte Halbleiterschaltung nach einem der Ansprüche 2, 4 oder 6, dadurch gekennzeichnet, dass der Verstärker (3) eine Serienschaltung von zwei mittels je eines Operationsverstärkers (20) aufgebauten invertierenden Verstärkern (3a, 3b) ist, wobei jeweils der Ausgang und der invertierende Eingang des Operationsverstärkers (20) über den als Rückkopplungskondensator (Cf) dienenden einen Kondensator (C2 bzw. C1) miteinander verbunden sind, während ein erster Schalter (21), der als Eingangskondensator (Ci) dienende andere Kondensator (C1 bzw. C2) und ein zweiter Schalter (22) in der angegebenen Reihenfolge in Reihe geschaltet und zwischen einem Eingangspol des Verstärkers (3a, 3b) und dem invertierenden Eingang des zugehörigen Operationsverstärkers (20) angeordnet sind, und wobei die beiden Pole des Eingangskondensators (Ci) je über einen dritten bzw. vierten Schalter (23, 24) an Masse liegen und der Rückkopplungskondensator (Cf) durch einen fünften Schalter (25) überbrückt ist.

## Claims

**1.** An integrated semiconductor circuit comprising a magnetic field sensor (1) of semiconductor material, whose output voltage ($u_H$) is inversely proportional to the charge carrier concentration (n) in the semiconductor material, an output useful signal ($u_A$, $F_A$) which is proportional to the output voltage ($u_H$) of the magnetic field sensor (1), and an amplifier (3) as a correction member, which is provided with resistors (R1, R2) which are diffused in the same semiconductor material from which the magnetic field sensor (1) is produced and whose gain factor serves for compensation of changes in sensitivity of the magnetic field sensor (1), characterised in that, to improve the long-term stability of the magnetic field sensor (1), a constant reference voltage ($U_R$) is applied at the input of the amplifier (3) and the output of the amplifier (3) is connected to a first input of a multiplier (8) whose second input is connected to a mains voltage ($U_N$) and whose output is connected by way of a voltage-current converter (2) to the feed current input (I1; I2; I3) of the magnetic field sensor (1), the gain factor of the amplifier (3) is proportional to the ratio (R1/R2) of the resistances of a first to a second resistor (R1 and R2 respectively) of the amplifier (3), the charge carrier concentration (m1) in the first resistor (R1) is equal to the charge carrier concentration (n) existing in the magnetic field sensor (1) and the charge carrier concentration (m2) in the second resistor (R2) is equal to half the charge carrier concentration (n/2) of the charge carrier concentration (m1 = n) existing in the first resistor (R1), both resistors (R1, R2) are of approximately the same dimensions as the magnetic field sensor (1) and are diffused in the semiconductor material near the magnetic field sensor (1) so that the changes ($\delta n$, $\delta m1$, $\delta m2$) in respect of time in the charge carrier concentrations (n, m1, m2) of the magnetic field sensor (1) and the resistors (R1, R2) are equal, whereby a change $\delta n$ in respect of time in the charge carrier concentration n in the magnetic field sensor (1) is compensated by multiplication of the feed current (i) of the magnetic field sensor (1) by a correction factor which is proportional to the factor $1 + \delta n/n$ in the amplifier (3).

**2.** An integrated semiconductor circuit comprising a magnetic field sensor (1) of semiconductor material, whose output voltage ($u_H$) is inversely proportional to the charge carrier concentration (n) in the semiconductor material, an output useful signal ($u_A$, $f_A$) which is proportional to the output voltage ($u_H$) of the magnetic field sensor (1), and an amplifier (3) as a correction member, whose gain factor serves for compensation of changes in sensitivity of the magnetic field sensor (1), characterised in that, to improve the long-term stability of the magnetic field sensor (1), a constant reference voltage ($U_R$) is applied at the input of the amplifier (3) and the output of the amplifier (3) is connected to a first input of a multiplier (8) whose second input is connected to a mains voltage ($U_N$) and whose output is

18

connected by way of a voltage-current converter (2) to the feed current input (I1; I2; I3) of the magnetic field sensor (1), the gain factor of the amplifier (3) is proportional to the square of the ratio (C1/C2) of the capacitances of a junction capacitor (C1) to a second capacitor (C2) of the amplifier (3), wherein the second capacitor (C2) is not a junction capacitor and has a constant capacitance which is independent of the charge carrier concentration, the charge carrier concentration (m) in the junction capacitor (C1) is equal to the charge carrier concentration (n) existing in the magnetic field sensor (1) and the junction transistor (C1) is diffused in the semiconductor material near the magnetic field sensor (1) so that the changes ($\delta n$, $\delta m$) in respect of time in the charge carrier concentrations (n, m) of the magnetic field sensor (1) and the junction capacitor (C1) are equal, whereby a change $\delta n$ in respect of time in the charge carrier concentration n in the magnetic field sensor 1 is compensated by multiplication of the feed current (i) of the magnetic field sensor (1) by a correction factor which is proportional to the factor $1 + \delta n/n$ in the amplifier (3).

3. An integrated semiconductor circuit comprising a magnetic field sensor (1) of semiconductor material, whose output voltage ($u_H$) is inversely proportional to the charge carrier concentration (n) in the semiconductor material, an output useful signal ($u_A$, $f_A$) which is proportional to the output voltage ($u_H$) of the magnetic field sensor (1), and an amplifier (3) which is connected in series downstream of the magnetic field sensor (1) as a correction member and which is provided with resistors (R1, R2) which are diffused in the same semiconductor material from which the magnetic field sensor (1) is produced and whose gain factor serves for compensation of changes in sensitivity of the magnetic field sensor (1), characterised in that, to improve the long-term stability of the magnetic field sensor (1), the gain factor of the amplifier (3) is proportional to the ratio (R1/R2) of the resistances of a first to a second resistor (R1 and R2 respectively) of the amplifier (3), the charge carrier concentration (m1) in the first resistor (R1) is equal to the charge carrier concentration (n) existing in the magnetic field sensor (1) and the charge carrier concentration (m2) in the second resistor (R2) is equal to half the charge carrier concentration (n/2) of the charge carrier concentration (m1 = n) existing in the first resistor (R1), both resistors (R1, R2) are of approximately the same dimensions as the magnetic field sensor (1) and are diffused in the semiconductor material near the magnetic field sensor (1) so that the changes ($\delta n$, $\delta m1$, $\delta m2$) in respect of time in the charge carrier concentrations (n, m1, m2) of the magnetic field sensor (1) and the resistors (R1, R2) are equal, whereby a change $\delta n$ in respect of time in the charge carrier concentration n in the magnetic field sensor (1) is compensated by multiplication of the output voltage ($u_H$) of the magnetic field sensor (1) by a correction factor which is proportional to the factor $1 + \delta n/n$ in the amplifier (3).

4. An integrated semiconductor circuit comprising a magnetic field sensor (1) of semiconductor material, whose output voltage ($u_H$) is inversely proportional to the charge carrier concentration (n) in the semiconductor material, an output useful signal ($u_A$, $f_A$) which is proportional to the output voltage ($u_H$) of the magnetic field sensor (1), and an amplifier (3) which is connected in series downstream of the magnetic field sensor (1) as a correction member and whose gain factor serves for compensation of changes in sensitivity of the magnetic field sensor (1), characterised in that, to improve the long-term stability of the magnetic field sensor (1), the gain factor of the amplifier (3) is proportional to the square of the ratio (C1/C2) of the capacitances of a junction capacitor (C1) to a second capacitor (C2) of the amplifier (3), wherein the second capacitor (C2) is not a junction capacitor and has a constant capacitance which is independent of the charge carrier concentration, the charge carrier concentration (m) in the junction capacitor (C1) is the same as the charge carrier concentration (n) existing in the magnetic field sensor (1) and the junction capacitor (C1) is diffused in the semiconductor material near the magnetic field sensor (1) so that the changes ($\delta n$, $\delta m$) in respect of time in the charge carrier concentrations (n, m) of the magnetic field sensor (1) and the junction capacitor (C1) are the same, whereby a change $\delta n$ in respect of time in the charge carrier concentration n in the magnetic field sensor (1) is compensated by multiplication of the output voltage ($u_H$) of the magnetic field sensor (1) by a correction factor which is proportional to the factor $1 + \delta n/n$ in the amplifier (3).

5. An integrated semiconductor circuit comprising a magnetic field sensor (1) of semiconductor material, whose output voltage ($u_H$) is inversely proportional to the charge carrier concentration (n) in the semiconductor material, an output useful signal ($u_A$, $f_A$) which is proportional to the output voltage ($u_H$) of the magnetic field sensor (1), and an amplifier (3) as a correction member, which is provided with resistors (R1, R2) which are diffused in the same semiconductor material from which the magnetic field sensor (1) is produced and whose gain factor serves for compensation of changes in sensitivity of the magnetic field sensor (1), characterised in that, to improve the long-term stability of the magnetic field sensor (1), a converter (4) is connected in series downstream of the magnetic field sensor (1), the converter (4) has a reference voltage input (5; 6) which is connected to the output of the amplifier (3), the output voltage ($u_H$) of the magnetic field sensor (1) is divided in the converter (4) by the output voltage ($U_V$) of the amplifier (3), the amplifier (3) has a constant reference voltage ($U_R$) as the input voltage, the gain factor of the amplifier (3) is proportional to the ratio (R2/R1) of the resistances of a second to a first resistor (R2 and R1 respectively) of the amplifier (3), the charge carrier concentration (m1) in the first resistor (R1) is equal to the charge carrier concentration (n) existing in the magnetic field sensor (1) and the charge carrier concentration (m2) in the second resistor (R2) is equal to half the charge carrier concentration (n/2) of the charge carrier concentration (m1 = n) existing in the first resistor (R1), both resistors (R1, R2) are of approximately the same dimensions as the magnetic field sensor (1) and are diffused in the semiconductor material near the magnetic field sensor (1) so that the changes ($\delta n$, $\delta m1$, $\delta m2$) in respect of time in the charge carrier concentrations (n, m1, m2) of the magnetic field sensor (1) and the resistors (R1, R2) are equal whereby a change $\delta n$ in respect of time in the charge carrier concentration n in the magnetic field sensor (1) is compensated by multiplication of the output voltage ($u_H$) of the magnetic field sensor (1) by a correction factor which is proportional to the factor 1 + $\delta n/n$ in the converter (4).

6. An integrated semiconductor circuit comprising a magnetic field sensor (1) of semiconductor material, whose output voltage ($u_H$) is inversely proportional to the charge carrier concentration (n) in the semiconductor material, an output useful signal ($u_A$, $f_A$) which is proportional to the output voltage ($u_H$) of the magnetic field sensor (1) and an amplifier (3) as a correction member, whose gain factor serves for compensation of changes in sensitivity of the magnetic field sensor (1), characterised in that, to improve the long-term stability of the magnetic field sensor (1), a converter (4) is connected in series downstream of the magnetic field sensor (1), the converter (4) has a reference voltage input (5; 6) which is connected to the output of the amplifier (3), the output voltage ($u_H$) of the magnetic field sensor (1) is divided in the converter (4) by the output voltage ($U_V$) of the amplifier (3), the amplifier (3) has a constant reference voltage ($U_R$) as the input voltage, the gain factor of the amplifier (3) is proportional to the square of the ratio (C1/C2) of the capacitances of a junction capacitor (C1) to a second capacitor (C2) of the amplifier (3), wherein the second capacitor (C2) is not a junction capacitor and has a constant capacitance which is independent of the charge carrier concentration, the charge carrier concentration (m) in the junction capacitor (C1) is the same as the charge carrier concentration (n) existing in the magnetic field sensor (1) and the junction capacitor (C1) is diffused in the semiconductor material near the magnetic field sensor (1) so that the changes ($\delta n$, $\delta m$) in respect of time in the charge carrier concentrations (n, m) of the magnetic field sensor (1) and the junction capacitor (C1) are the same, whereby a change $\delta n$ in respect of time in the charge carrier concentration n in the magnetic field sensor (1) is compensated by multiplication of the output voltage ($u_H$) of the magnetic field sensor (1) by a correction factor which is proportional to the factor 1 + $\delta n/n$ in the converter (4).

7. An integrated semiconductor circuit comprising a first magnetic field sensor (1) of semiconductor material, whose output voltage ($u_H$) is inversely proportional to the charge carrier concentration (n) in the semiconductor material, and an output useful signal ($u_A$, $f_A$) which is proportional to the output voltage ($u_H$) of the first magnetic field sensor (1), characterised in that, to improve the long-term stability of the first magnetic field sensor (1), there is a further magnetic field sensor circuit (29) which includes a second magnetic field sensor (1a) as a correction member, a converter (4) is connected in series downstream of the first magnetic field sensor (1), the converter (4) has a reference voltage input (5; 6) which is connected to the output of the further magnetic field sensor circuit (29), the output voltage ($u_H$) of the first magnetic field sensor (1) is divided in the converter (4) by the output voltage ($U_V$) of the further magnetic field sensor circuit (29), the further magnetic field sensor circuit (29) has a constant reference voltage ($U_R$) as the input voltage, the charge carrier concentrations (n) in the two magnetic field sensors (1, 1a) are the same, both magnetic field sensors (1, 1a) are of approximately the same dimensions and are arranged close to each other in the semiconductor material so that the changes ($\delta n$) in respect of time in the charge carrier concentrations (n) of the two magnetic field sensors (1, 1a) are equal, whereby a change $\delta n$ in respect of time in the charge carrier concentration n in the first magnetic field sensor (1) is compensated by multiplication of the output voltage ($u_H$) of the first magnetic field sensor (1) by a correction factor which is proportional to the factor 1 + $\delta n/n$ in the converter (4).

**8.** An integrated semiconductor circuit comprising a magnetic field sensor (1) of semiconductor material, whose output voltage ($u_H$) is inversely proportional to the charge carrier concentration (n) in the semiconductor material, an output useful signal ($u_A$, $f_A$) which is proportional to the output voltage ($u_H$) of the magnetic field sensor (1), and an impedance converter (31) which is connected in series upstream of the magnetic field sensor (1) as a correction member and which has a resistor (R) which is diffused in the same semiconductor material from which the magnetic field sensor (1) is produced and which serves for compensation of changes in sensitivity of the magnetic field sensor (1), characterised in that, to improve the long-term stability of the magnetic field sensor (1), the impedance converter (31) includes a voltage follower (32), the resistor (R) of the impedance converter (31) is connected by way of the voltage follower (32) in two-pole mode to the feed current input (I1; I2; I3) of the magnetic field sensor (1), the impedance converter (31) is fed with a current (i) by a voltage-current converter (2), the charge carrier concentration (m) in the resistor (R) of the impedance converter (31) is approximately at least five times as high as that of the magnetic field sensor (1), the resistor (R) of the impedance converter (31) is diffused in the semiconductor material near the magnetic field sensor (1) so that the changes ($\delta n$, $\delta m$) in respect of time in the charge carrier concentrations (n, m) of the magnetic field sensor (1) and the resistor (R) of the impedance converter (31) are equal, whereby a change $\delta n$ in respect of time in the charge carrier concentration n in the magnetic field sensor (1) is compensated by multiplication of the output voltage ($u_H$) of the magnetic field sensor (1) by a correction factor which is proportional to the factor $1 + \delta n/n$ in the impendance converter (31).

**9.** An integrated semiconductor circuit according to one of claims 1, 3 or 5 characterised in that the amplifier (3) comprises an inverting amplifier which is constructed by bans of an operational amplifier (11), wherein one of the two resistors (R1 or R2) is arranged as a feedback resistor (Rf) between the output of the operational amplifier (11) and its inverting input while the other of the two resistors (R2 or R1 respectively) is disposed as an input resistor (Ri) upstream of the inverting input of the operational amplifier (11).

**10.** An integrated semiconductor circuit according to one of claims 1, 3 or 5 characterised in that the amplifier (3) comprises a series circuit of two inverting amplifiers (12; 13) which are each constructed by means of a respective operational amplifier (12a; 13a), wherein one of the two resistors (R1 or R2) is arranged as a feedback resistor (Rf) between the output of the operational amplifier (12a) of the front inverting amplifier (12) and the inverting input of said operational amplifier (12a) while the other of the two resistors (R2 or R1 respectively) is connected as an input resistor (Ri) upstream of the inverting input of the operational amplifier (13a) of the rear inverting amplifier (13), and wherein a third resistor (R3) is connected as an input resistor upstream of the inverting input of the operational amplifier (12a) of the front inverting amplifier (12) while a fourth resistor (R4) is arranged as a feedback resistor between the output of the operational amplifier (13a) of the rear inverting amplifier (13) and the inverting input of said operational amplifier (13a).

**11.** An integrated semiconductor circuit according to one of claims 2, 4 or 6 characterised in that the amplifier (3) is a series circuit of two inverting amplifiers (3a, 3b) which are each constructed by means of a respective operational amplifier (20), wherein in each case the output and the inverting input of the operational amplifier (20) are connected together by way of the one capacitor (C2 or C1) which serves as a feedback capacitor (Cf) while a first switch (21), the other capacitor (C1 or C2 respectively) serving as the input capacitor (Ci) and a second switch (22) are connected in series in the specified sequence and are arranged between an input pole of the amplifier (3a, 3b) and the inverting input of the associated operational amplifier (20), and wherein the two poles of the input capacitor (ci) are connected to earth by way of third and fourth switches (23, 24) respectively and the feedback capacitor (Cf) is shunted by a fifth switch (25).

## Revendications

**1.** Circuit intégré à semi-conducteurs, comprenant un détecteur (1) de champ magnétique en matière semi-conductrice, dont la tension de sortie ($u_H$) est inversement proportionnelle à la concentration (n) des porteurs de charge dans la matière semi-conductrice, un signal utile de sortie ($u_A$, $f_A$), qui est proportionnel à la tension de sortie ($u_H$) du détecteur (1) de champ magnétique, ainsi qu'un amplificateur (3) constituant un organe correcteur et comprenant des résistances (R1, R2) qui sont réalisées par diffusion en la même matière semi-conductrice que celle en laquelle le détecteur (1) de champ

21

magnétique est réalisé et dont le facteur d'amplification est destiné à la compensation des variations de sensibilité du détecteur (1) de champ magnétique, caractérisé en ce que, pour améliorer la stabilité à long terme du détecteur (1) de champ magnétique, l'entrée de l'amplificateur (3) reçoit une tension constante de référence ($U_R$) et la sortie de l'amplificateur (3) est connectée à une première entrée d'un multiplicateur (8) dont la seconde entrée est à la tension du réseau ($u_N$) et dont la sortie est connectée par l'intermédiaire d'un transformateur (2) de tension en courant à l'entrée (I1 ; I2 ; I3) du courant d'alimentation du détecteur (1) de champ magnétique, le facteur d'amplification de l'amplificateur (3) est proportionnel au rapport (R1/R2) des valeurs de résistance d'une première et d'une seconde résistances (R1 ainsi que R2) de l'amplificateur (3), la concentration (m1) des porteurs de charge dans la première résistance (R1) est égale à la concentration (n) des porteurs de charge qui existe dans le détecteur (1) de champ magnétique et la concentration (m2) des porteurs de charge dans la seconde résistance (R2) est égale à la moitié (n/2) de la concentration (m1 = n) des porteurs de charge existant dans la première résistance (R1), les deux résistances (R1, R2) ont approximativement les mêmes cotes que celles du détecteur (1) de champ magnétique et sont réalisées par diffusion à proximité du détecteur (1) de champ magnétique dans la matière semi-conductrice, de manière que les variations dans le temps ( $\delta n$, $\delta m1$, $\delta m2$) des concentrations (n, m1, m2) des porteurs de charge du détecteur (1) de champ magnétique et des résistances (R1, R2) soient égales, de sorte qu'une variation dans le temps $\delta n$ de la concentration n des porteurs de charge dans le détecteur (1) de champ magnétique est compensée par multiplication du courant d'alimentation (i) du détecteur (1) de champ magnétique par un facteur de correction, qui est proportionnel au facteur 1 + $\delta n/n$, dans l'amplificateur (3).

2. Circuit intégré à semi-conducteurs, comprenant un détecteur (1) de champ magnétique en matière semi-conductrice, dont la tension de sortie ($u_H$) est inversement proportionnelle à la concentration (n) des porteurs de charge dans la matière semi-conductrice, un signal utile de sortie ($u_A$, $f_A$) qui est proportionnel à la tension de sortie ($u_H$) du détecteur (1) de champ magnétique, ainsi qu'un amplificateur (3) constituant un organe correcteur et dont le facteur d'amplification est destiné à la compensation des variations de sensibilité du détecteur (1) de champ magnétique, caractérisé en ce que, pour améliorer la stabilité à long terme du détecteur (1) de champ magnétique, l'entrée de l'amplificateur (3) reçoit une tension constante de référence ($U_R$) et la sortie de l'amplificateur (3) est connectée à une première entrée d'un multiplicateur (8) dont la seconde entrée est à une tension du réseau ($u_N$) et dont la sortie est connectée par l'intermédiaire d'un transformateur de tension en courant (2) à l'entrée (I1 ; I2 ; I3) du courant d'alimentation du détecteur (1) de champ magnétique, le facteur d'amplification de l'amplificateur (3) est proportionnel au carré du rapport (C1/C2) des capacités d'un condensateur à jonction (C1) et d'un second condensateur (C2) de l'amplificateur (3), le second condensateur (C2) n'étant pas un condensateur à jonction et ayant une capacité constante, indépendante de la concentration des porteurs de charge, la concentration (m) des porteurs de charge dans le condensateur à jonction (C1) étant égale à la concentration (n) des porteurs de charge existant dans le détecteur (1) de champ magnétique et le condensateur à jonction (C1) est réalisé à proximité du détecteur (1) de champ magnétique par diffusion dans la matière semi-conductrice, de façon que les variations dans le temps ($\delta n$, $\delta m$) des concentrations (n, m) des porteurs de charge du détecteur (1) de champ magnétique et du condensateur à jonction (C1) soient égales, de sorte qu'une variation dans le temps $\delta n$ de la concentration n des porteurs de charge dans le détecteur (1) de champ magnétique est compensée par multiplication du courant (i) d'alimentation du détecteur (1) de champ magnétique par un facteur de correction, qui est proportionnel au facteur 1 + $\delta n/n$, dans l'amplificateur (3).

3. Circuit intégré à semi-conducteurs, comprenant un détecteur (1) de champ magnétique en matière semi-conductrice, dont la tension de sortie ($u_H$) est inversement proportionnelle à la concentration (n) des porteurs de charge dans la matière semi-conductrice, un signal utile de sortie ($u_A$, $f_A$) qui est proportionnel à la tension de sortie ($u_H$) du détecteur (1) de champ magnétique, ainsi qu'un amplificateur (3) monté en série en aval du détecteur (1) de champ magnétique et constituant un organe correcteur, qui comprend des résistances (R1, R2) qui sont réalisées par diffusion en la même matière semi-conductrice que celle en laquelle le détecteur (1) de champ magnétique est réalisé et dont le facteur d'amplification est destiné à la compensation des variations de sensibilité du détecteur (1) de champ magnétique, caractérisé en ce que, pour améliorer la stabilité à long terme du détecteur (1) de champ magnétique, le facteur d'amplification de l'amplificateur (3) est proportionnel au rapport (R1/R2) des valeurs de résistance d'une première et d'une seconde résistances (R1 ainsi que R2) de l'amplificateur (3), la concentration (m1) des porteurs de charge dans la première résistance (R1) est égale à la concentration (n) des porteurs de charge existant dans le détecteur (1) de champ magnétique et la concentration (m2) des porteurs de charge dans la seconde résistance (R2) est égale à la moitié (n/2) de la concentration (m1 = n) des porteurs de charge existant dans la première résistance (R1), les deux résistances (R1, R2) ont approximativement les mêmes cotes que le détecteur (1) de champ magnétique et sont réalisées à proximité du détecteur (1) de champ magnétique par diffusion dans la matière semi-conductrice, de façon que les variations dans le temps ($\delta$n, $\delta$m1, $\delta$m2) des concentrations (n, m1, m2) des porteurs de charge du détecteur (1) de champ magnétique et des résistances (R1, R2) soient égales, de sorte qu'une variation dans le temps $\delta$n de la concentration n des porteurs de charge dans le détecteur (1) de champ magnétique est compensée par multiplication de la tension de sortie ($u_H$) du détecteur (1) de champ magnétique par un facteur de correction, qui est proportionnel au facteur 1 + $\delta$n/n, dans l'amplificateur (3).

4. Circuit intégré à semi-conducteurs, comprenant un détecteur (1) de champ magnétique en matière semi-conductrice, dont la tension de sortie ($u_H$) est inversement proportionnelle à la concentration (n) des porteurs de charge dans la matière semi-conductrice, un signal utile de sortie ($u_A$, $f_A$) qui est proportionnel à la tension de sortie ($u_H$) du détecteur (1) de champ magnétique, ainsi qu'un amplificateur (3) monté en série en aval du détecteur (1) de champ magnétique et constituant un organe correcteur, dont le facteur d'amplification est destiné à la compensation des variations de sensibilité du détecteur (1) de champ magnétique, caractérisé en ce que, pour améliorer la stabilité à long terme du détecteur (1) de champ magnétique, le facteur d'amplification de l'amplification (3) est proportionnel au carré du rapport (C1/C2) des capacités d'un condensation à jonction (C1) et d'un second condensateur (C2) de l'amplificateur (3), le second condensateur (C2) n'étant pas un condensateur à jonction et ayant une capacité constante qui est indépendante de la concentration des porteurs de charge, la concentration (m) des porteurs de charge dans le condensateur à jonction (C1) étant égale à la concentration (n) des porteurs de charge existant dans le détecteur (1) de champ mangétique et le condensateur à jonction (C1) étant réalisé à proximité du détecteur (1) de champ magnétique par diffusion dans la matière semi-conductrice, de façon que les variations dans le temps ($\delta$n,$\delta$m) des concentrations (n, m) des porteurs de charge du détecteur (1) de champ magnétique et du condensateur à jonction (C1) soient égales, de sorte qu'une variation dans le temps $\delta$n de la concentration n des porteurs de charge dans le détecteur (1) de champ magnétique est compensée par multiplication de la tension de sortie ($u_H$) du détecteur (1) de champ magnétique par un facteur de correction, qui est proportionnel au facteur 1 + $\delta$n/n, dans l'amplificateur (3).

5. Circuit intégré à semi-conducteurs, comprenant un détecteur (1) de champ magnétique en matière semi-conductrice, dont la tension de sortie ($u_H$) est inversement proportionnelle à la concentration (n) des porteurs de charge dans la matière semi-conductrice, un signal utile de sortie ($u_A$, $f_A$) qui est proportionnel à la tension de sortie ($u_H$) du détecteur (1) de champ magnétique, ainsi qu'un amplificateur (3) constituant un organe correcteur et comportant des résistances (R1, R2) qui sont réalisées par diffusion en la même matière semi-conductrice en laquelle le détecteur (1) de champ magnétique est réalisé et dont le facteur d'amplification est destiné à la compensation des variations de sensibilité du détecteur (1) de champ magnétique, caractérisé en ce que, pour améliorer la stabilité à long terme du détecteur (1) de champ magnétique, un convertisseur (4) est monté en série en aval du détecteur (1) de champ magnétique, le convertisseur (4) comprend une entrée (5;6) de tension de référence qui est connectée à la sortie de l'amplificateur (3), la tension de sortie ($u_H$) du détecteur (1) de champ magnétique est divisée dans le convertisseur (4) par la tension de sortie ($U_V$) de l'amplificateur (3), l'amplificateur (3) a une tension d'entrée qui est une tension constante de référence ($U_R$), le facteur d'amplification de l'amplificateur (3) est proportionnel au rapport (R2/R1) des valeurs des résistances d'une seconde et d'une première résistances (R2 ainsi que R1) de l'amplificateur (3), la concentration (m1) des porteurs de charge dans la première résistance (R1) est égale à la concentration (n) des porteurs de charge qui existe dans le détecteur (1) de champ magnétique et la concentration (m2) des porteurs de charge dans la seconde résistance (R2) est égale à la moitié (n/2) de la concentration (m1 = n) des porteurs de charge existant dans la première résistance (R1), les deux résistances (R1, R2) ont approximativement les mêmes cotes que le détecteur (1) de champ magnétique et sont réalisées à proximité du détecteur (1) de champ magnétique par diffusion dans la matière semi-conductrice, de façon que les variations temporelles ($\delta$n, $\delta$m1, $\delta$m2) des concentrations (n, m1, m2) des porteurs de charge du détecteur (1) de champ magnétique et des résistances (R1, R2) soient égales, de sorte qu'une variation dans le temps $\delta$n de la concentration n des porteurs de charge dans le détecteur (1) de champ magnétique est compensée par multiplication de la tension de sortie ($u_H$) du détecteur (1) de champ magnétique par un facteur de correction, qui est proportionnel au facteur 1 + $\delta$n/n, dans le

EP 0 338 122 B1

convertisseur (4).

**6.** Circuit intégré à semi-conducteurs, comprenant un détecteur (1) de champ magnétique en matière semi-conductrice, dont la tension de sortie ($u_H$) est inversement proportionnelle à la concentration (n) des porteurs de charge dans la matière semi-conductrice, un signal utile de sortie ($u_A$, $f_A$) qui est proportionnel à la tension de sortie ($u_H$) du détecteur (1) de champ magnétique, ainsi qu'un amplificateur (3) qui constitue un organe de correction et dont le facteur d'amplification est destiné à la compensation de sensibilité du détecteur (1) de champ magnétique, caractérisé en ce que, pour améliorer la stabilité à long terme du détecteur (1) de champ magnétique, un convertisseur (4) est monté en série en aval du détecteur (1) de champ magnétique, le convertisseur (4) comporte une entrée (5 ; 6) de tension de référence qui est connectée à la sortie de l'amplificateur (3), la tension de sortie ($u_H$) du détecteur (1) de champ magnétique est divisée dans le convertisseur (4) par la tension de sortie ($U_V$) de l'amplificateur (3), l'amplificateur (3) a une tension d'entrée qui est une tension constante de référence ($U_R$), le facteur d'amplification de l'amplificateur (3) est proportionnel au carré du rapport (C1/C2) des capacités d'un condensateur à jonction (C1) et d'un second condensateur (C2) de l'amplificateur (3), le second condensateur (C2) n'étant pas un condensateur à jonction et ayant une capacité constante qui est indépendante de la concentration des porteurs de charge, la concentration (n) des porteurs de charge dans le condensateur à jonction (C1) étant égale à la concentration (n) des porteurs de charge existant dans le détecteur (1) de champ magnétique et le condensateur à jonction (C1) étant réalisé à proximité du détecteur (1) de champ magnétique par diffusion dans la matière semi-conductrice, de façon que les variations dans le temps ($\delta n$, $\delta m$) des concentrations (n, m) des porteurs de charge du détecteur (1) de champ magnétique et du condensateur à jonction (C1) soient égales, de sorte qu'une variation dans le temps $\delta n$ de la concentration n des porteurs de charge dans le détecteur (1) de champ magnétique est compensée par multiplication de la tension de sortie ($u_H$) du détecteur (1) de champ magnétique par un facteur de correction, qui est proportionnel au facteur $1 + \delta n/n$, dans le convertisseur (4).

**7.** Circuit intégré à semi-conducteurs, comprenant un premier détecteur (1) de champ magnétique en matière semi-conductrice, dont la tension ($u_H$) est inversement proportionnelle à la concentration (n) des porteurs de charge dans la matière semi-conductrice, ainsi qu'un signal utile de sortie ($u_A$, $f_A$) qui est proportionnel à la tension de sortie ($u_H$) du premier détecteur (1) de champ magnétique, caractérisé en ce que, pour améliorer la stabilité à long terme du premier détecteur (1) de champ magnétique, un autre circuit (29) à détecteur de champ magnétique, qui comprend un second détecteur (1a) de champ magnétique qui constitue un organe correcteur, est prévu, un convertisseur (4) est monté en série en aval du premier détecteur (1) de champ magnétique, le convertisseur (4) a une entrée (5;6) de tension de référence qui est connectée à la sortie de l'autre circuit (29) à détecteur de champ magnétique, la tension de sortie ($u_H$) du premier détecteur (1) de champ magnétique est divisée dans le convertisseur (4) par la tension de sortie ($U_V$) de l'autre circuit (29) à détecteur de champ magnétique, l'autre circuit (29) à détecteur de champ magnétique a une tension d'entrée qui est une tension constante de référence ($U_R$), la concentration (n) des porteurs de charge est égale dans les deux détecteurs de champ magnétique (1, 1a), les deux détecteurs (1, 1a) de champ magnétique ont approximativement les mêmes cotes et sont disposés dans la matière semi-conductrice à proximité l'un de l'autre, de façon que les variations dans le temps ($\delta n$) des concentrations (n) des porteurs de charge des deux détecteurs (1, 1a) de champ magnétique soient égales, de sorte qu'une variation dans le temps $\delta n$ de la concentration n des porteurs de charge dans le premier détecteur (1) de champ magnétique est compensée par multiplication de la tension de sortie ($u_H$) du premier détecteur (1) de champ magnétique par un facteur de correction, qui est proportionnel au facteur $1 + \delta n/n$, dans le convertisseur (4).

**8.** Circuit intégré à semi-conducteurs, comprenant un détecteur (1) de champ magnétique en matière semi-conductrice, dont la tension de sortie ($u_H$) est inversement proportionnelle à la concentration (n) des porteurs de charge dans la matière semi-conductrice, un signal utile de sortie ($u_A$, $f_A$) qui est proportionnel à la tension de sortie ($u_H$) du détecteur (1) de champ magnétique, ainsi qu'un transformateur d'impédance (31) qui est monté en série en amont du détecteur (1) de champ magnétique pour servir d'organe correcteur et qui comporte une résistance (R) réalisée par diffusion en la même matière semi-conductrice que celle en laquelle le détecteur (1) de champ magnétique est réalisé, ledit transformateur d'impédance (31) étant destiné à la compensation des variations de sensibilité du détecteur (1) de champ magnétique, caractérisé en ce que, pour améliorer la stabilité à long terme du

24

détecteur (1) de champ magnétique, le transformateur d'impédance (31) comprend un élément (32) asservi en tension, les deux pôles de la résistance (R) du transformateur d'impédance (31) sont connectés par l'intermédiaire de l'élément (32) asservi en tension à l'entrée (I1 ; I2 ; I3) du courant d'alimentation du détecteur (1) de champ magnétique, le transformateur d'impédance (31) est alimenté en un courant (i) au moyen d'un transformateur de tension en courant (2), la concentration (m) des porteurs de charge dans la résistance (R) du transformateur d'impédance (31) est environ cinq fois plus grande que celle du détecteur (1) de champ magnétique, la résistance (R) du transformateur d'impédance (31) est réalisée à proximité du détecteur (1) de champ magnétique par diffusion dans la matière semi-conductrice, de façon que les variations dans le temps ( $\delta n$, $\delta m$) des concentrations (n, m) des porteurs de charge du détecteur (1) de champ magnétique et de la résistance (R) du transformateur d'impédance (31) soient égales, de sorte qu'une variation dans le temps $\delta n$ de la concentration n des porteurs de charge dans le détecteur (1) de champ magnétique est compensée par multiplication de la tension de sortie ($u_H$) du détecteur (1) de champ magnétique par un facteur de correction, qui est proportionnel au facteur $1 + \delta n/n$, dans le transformateur d'impédance (31).

9. Circuit intégré à semi-conducteurs selon l'une des revendications 1, 3 ou 5, caractérisé en ce que l'amplificateur (3) consiste en un amplificateur inverseur réalisé au moyen d'un amplificateur opérationnel (11), l'une des deux résistances (R1 ou R2) étant disposée de manière à former une résistance de réaction (Rf) entre la sortie de l'amplificateur opérationnel (11) et son entrée inverseuse, tandis que l'autre des deux résistances (R2 ou R1) constitue une résistance d'entrée (Ri) montée en amont de l'entrée inverseuse de l'amplificateur opérationnel (11).

10. Circuit intégré à semi-conducteurs selon l'une des revendications 1, 3 ou 5, caractérisé en ce que l'amplificateur (3) se compose d'un montage en série de deux amplificateurs inverseurs (12 ; 13), dont chacun est réalisé au moyen d'un amplificateur opérationnel (12a ; 13a), l'une des deux résistances (R1 ou R2) constituant une résistance de réaction (Rf) qui est montée entre la sortie de l'amplificateur opérationnel (12a) du premier amplificateur inverseur (12) et l'entrée inverseuse de cet amplificateur opérationnel (12a), tandis que l'autre des deux résistances (R2 ainsi que R1) constitue une résistance d'entrée (Ri) qui est montée en amont de l'entrée inverseuse de l'amplificateur opérationnel (13a) du dernier amplificateur inverseur (13) et une troisième résistance (R3) est montée en amont de l'entrée inverseuse de l'amplificateur opérationnel (12a) du premier amplificateur inverseur (12) de manière à constituer une résistance d'entrée, tandis qu'une quatrième résistance (R4) constitue une résistance de réaction qui est montée entre la sortie de l'amplificateur opérationnel (13a) du dernier amplificateur inverseur (13) et l'entrée inverseuse de cet amplificateur opérationnel (13a).

11. Circuit intégré à semi-conducteurs selon l'une des revendications 2, 4 ou 6, caractérisé en ce que l'amplificateur (3) consiste en un montage en série de deux amplificateurs inverseurs (3a, 3b) dont chacun est réalisé au moyen d'un amplificateur opérationnel (20), la sortie et l'entrée inverseuses de chaque amplificateur opérationnel (20) étant reliées l'une à l'autre par l'entremise de l'un des condensateurs (C2 ou C1) qui constitue un condensateur de réaction (Cf), tandis qu'un premier commutateur (21), l'autre condensateur (C1 ou C2) servant de condensateur d'entrée (Ci) ainsi qu'un second commutateur (22) sont montés en série dans la séquence indiquée et disposés entre un pôle d'entrée de l'amplificateur (3a, 3b) et l'entrée inverseuse de l'amplificateur opérationnel correspondant (20) et chacun des deux pôles du condensateur d'entrée (Ci) étant mis à la masse par un troisième et un quatrième commutateurs (23, 24) et le condensateur de réaction (Cf) étant shunté par un cinquième commutateur (25).

EP 0 338 122 B1

# Fig.1

# Fig.2

# Fig.3

# Fig.4

# Fig.5

## Fig. 6

## Fig. 7

## Fig. 8

## Fig. 9

## Fig. 10

## Fig. 11

17  I2  S1  I1  S2  I3  18  28  P⁺  19  15

P⁺  N⁺  N⁺  N⁻  N⁺  N⁺  N⁺  P⁺  C 1  N⁻  P⁺

1

14  P⁻

## Fig. 12

29

$I_R$  $B_0$  S1

$U_R$  I1  $U_{H,0}$  $U_V$

2a  I2;I3  1a  S2  30

## Fig.13

I  I1  S1  4

$u_N$  i  V  $u_H$  $u_A / f_A$

2  31  I2;I3  1  S2  5  6  7

$U_0$  fo

## Fig.14

31

33

i  −

+  I

V  R  V

32